# EUROPEAN PATENT APPLICATION

(11) **EP 4 625 493 A1**
(43) Date of publication of application: **01.10.2025**
(21) Application number: 23902374.0
(22) Date of filing: 09.11.2023
(51) Int. Cl.: H01L 25/065

(54) **CHIP INTEGRATED STRUCTURE AND MANUFACTURING METHOD THEREFOR, AND ELECTRONIC DEVICE**

(30) Priority: 15.12.2022 CN 202211626334
(71) Applicant: Huawei Technologies Co., Ltd., Shenzhen, Guangdong 518129 (CN)
(72) Inventor: LIU, Shuguang, Shenzhen, Guangdong 518129 (CN); ZHANG, Shiwei, Shenzhen, Guangdong 518129 (CN); JING, Weiliang, Shenzhen, Guangdong 518129 (CN); ZHANG, Chunyu, Shenzhen, Guangdong 518129 (CN)
(74) Representative: Isarpatent
(86) International application number: PCT/CN2023/130829
(87) International publication number: WO 2024/125174

(57) **Abstract**

Embodiments of this application provide a chip integrated structure, a manufacturing method therefor, and an electronic device, to resolve a problem that performance of a stacking layer is poor because a distance between adjacent functional chips in the same stacking layer is large and a quantity of functional chips disposed per unit area is reduced. The chip integrated structure includes a package substrate and a first chip structure layer. The first chip structure layer is located on a side of the package substrate, and is electrically connected to the package substrate. The first chip structure layer includes a scribe line structure and a plurality of first dies. The scribe line structure connects the plurality of first dies and electrically separates the plurality of first dies. The first die has an electrical function. The foregoing disposing helps reduce a spacing between adjacent first dies in the first chip structure layer, to increase a quantity of first dies per unit area in the first chip structure layer, and improve integration of the chip integrated structure and performance of the chip integrated structure.

## Description

This application claims priority to Chinese Patent Application No. 202211626334.0, filed with the China National Intellectual Property Administration on December 15, 2022 and entitled "CHIP INTEGRATED STRUCTURE AND MANUFACTURING METHOD THEREFOR, AND ELECTRONIC DEVICE", which is incorporated herein by reference in its entirety.

### TECHNICAL FIELD

This application relates to the field of chip technologies, and in particular, to a chip integrated structure and a manufacturing method therefor, and an electronic device.

### BACKGROUND

With rapid development of semiconductor technologies, a 3D IC (three-dimensional integrated circuit, three-dimensional integrated circuit) has been widely applied. The 3D IC means that a plurality of chips are vertically integrated and stacked in three-dimensional space, to reduce a package size, enhance chip performance, improve chip integration, and the like. The 3D IC technology has been successfully applied by many semiconductor manufacturers to produce products such as a CMOS (complementary metal oxide semiconductor, complementary metal oxide semiconductor) image sensor, a NAND flash (flash), and a high bandwidth memory (high bandwidth memory, HBM), and greatly enhance product performance. However, performance of a same stacking layer of a chip is poor.

### SUMMARY

Embodiments of this application provide a chip integrated structure, a manufacturing method therefor, and an electronic device, to resolve a problem that performance of a stacking layer is poor because a distance between adjacent functional chips in the same stacking layer is large and a quantity of functional chips disposed per unit area is reduced.

To achieve the foregoing objective, this application uses the following technical solutions.

According to one aspect, a chip integrated structure is provided, including a package substrate and a first chip structure layer. The first chip structure layer is located on a side of the package substrate, and is electrically connected to the package substrate. The first chip structure layer includes a scribe line structure and a plurality of first dies. The scribe line structure connects the plurality of first dies and electrically separates the plurality of first dies. The first die has an electrical function.

According to the chip integrated structure in the foregoing embodiment, the first chip structure layer includes the scribe line structure and the plurality of first dies, the scribe line structure connects the plurality of first dies and electrically separates the plurality of first dies, and the first die has the electrical function. Herein, the "electrical function" means that the first die has a component and can be powered on to work. The first die may include a digital chip, an analog chip, an optical chip, and the like. Each first die is one die. That is, the plurality of first dies are a plurality of dies located in a same wafer, and adjacent dies are connected through the scribe line structure. In other words, dicing is not performed on a scribe line region between the plurality of first dies, and therefore a scribe line structure is reserved. The foregoing disposing helps reduce a spacing between adjacent first dies in the first chip structure layer, to increase a quantity of first dies per unit area in the first chip structure layer, improve integration of the chip integrated structure, and enhance performance of the chip integrated structure. For example, when the first die includes a memory chip, the quantity of first dies per unit area in the first chip structure layer increases, and this helps increase a storage capacity of the first chip structure layer, and further helps increase a storage capacity of the chip integrated structure. When the first die includes a logic chip, a quantity of first dies per unit area in the first chip structure layer increases, and this helps increase a computing processing rate of the first chip structure layer, and further helps increase a computing processing rate of the chip integrated structure.

In addition, because the plurality of first dies are a plurality of dies located in the same wafer, the plurality of first dies may be obtained through one time of dicing. This helps improve processing efficiency of the chip integrated structure, and further improves a throughput of the chip integrated structure per unit time.

In some embodiments, the first die includes a first substrate, the scribe line structure includes a first connection substrate, and the first connection substrate and the first substrate are connected and are disposed at a same layer. For example, adjacent first substrates may be connected through a first connection substrate. Herein, "being disposed at a same layer" means using a same film forming process to form film layers for specific patterns on the first substrate and the first connection substrate, and then using a same mask to form layer structures through a single patterning process. The single patterning process may include a plurality of times of exposure, development, or etching processes, and the specific patterns in the formed layer structures have same materials.

In some embodiments, the first die further includes a seal ring, the seal ring is located in an edge region of the first die, and the seal ring is adjacent to the scribe line structure. The seal ring includes a plurality of seal layers that are stacked and a plurality of seal plugs. One seal plug is located between two adjacent seal layers, and the seal plug is in contact with the two adjacent seal layers. It may be understood that when dicing is performed on a scribe line structure adjacent to the first die, stress is easily transferred to the first die. This causes damage in the first die, and further degrades performance of the first die. The seal ring is disposed, to help reduce the stress transferred to the first die to reduce damage in the first die, and help enhance performance of the first die.

In some embodiments, the first die further includes a plurality of first insulation layers, the plurality of first insulation layers are located on the first substrate, and the plurality of first insulation layers are stacked. The scribe line structure further includes a plurality of first insulation connection layers, the plurality of first insulation connection layers are located on the first connection substrate, and the plurality of first insulation connection layers are stacked. The plurality of first insulation connection layers are connected to the plurality of first insulation layers in one-to-one correspondence, and a first insulation connection layer and a first insulation layer that are correspondingly connected are disposed at a same layer. For example, two corresponding first insulation layers in adjacent first dies are connected through a corresponding first insulation connection layer. Herein, "being disposed at a same layer" means using a same film forming process to form film layers for specific patterns on the first insulation layer and the first insulation connection layer, and then using a same mask to form layer structures through a single patterning process. The single patterning process may include a plurality of times of exposure, development, or etching processes, and the specific patterns in the formed layer structures have same materials.

In some embodiments, the first die further includes a plurality of first conductive layers, the plurality of first conductive layers are located on the first substrate, and the plurality of first conductive layers are stacked. The scribe line structure further includes the plurality of first insulation connection layers, the plurality of first insulation connection layers are located on the first connection substrate, and the plurality of first insulation connection layers are stacked. A quantity of the plurality of first insulation connection layers is the same as a quantity of the plurality of conductive layers. The first conductive layers include a plurality of layers of metal lines, and the metal lines are configured to electrically connect a plurality of electronic components together, to form a circuit structure of the first die. The electronic component may include, for example, a transistor, a capacitor, and a resistor. The first conductive layers and the first insulation layers that are stacked to jointly form a functional layer of the first die, to implement a storage, logic, or other function of the first die.

In some embodiments, the scribe line structure includes a plurality of metal layers, the plurality of metal layers are located on the first connection substrate, and the plurality of metal layers are stacked. The plurality of metal layers are in one-to-one correspondence with a part of the plurality of first conductive layers, and a metal layer and a first conductive layer that are in correspondence are disposed at a same layer and are electrically isolated from each other. For example, a plurality of metal layers may be disposed on the first connection substrate, and the plurality of metal layers may be stacked, and are located on a same side of the first connection substrate as the first insulation connection layer. The plurality of metal layers are in one-to-one correspondence with a part of the plurality of first conductive layers without contact, so that a metal layer and a first conductive layer that are in correspondence are electrically isolated from each other. Herein, "being disposed at a same layer" means using a same film forming process to form film layers for specific patterns on the metal layer and the first conductive layer, and then using a same mask to form layer structures through a single patterning process. The single patterning process may include a plurality of times of exposure, development, or etching processes, and the specific patterns in the formed layer structures have same materials.

In some embodiments, at least a part of the plurality of metal layers form a test structure. Herein, the test structure (Testkey) is tested by using a specific test machine, to reflect a process fluctuation in a manufacturing process of the first die and detect whether an exception occurs in a manufacturing line.

In some embodiments, the scribe line structure includes a positioning mark. For example, the first connection substrate is provided with at least one positioning mark; and/or at least one first insulation connection layer is provided with at least one positioning mark. In some embodiments, there may be only one positioning mark. The positioning mark may be provided on the first connection substrate, and is located between the first connection substrate and the first insulation connection layer; or the positioning mark may be stacked with the first insulation connection layer, and is located on a same side of the first connection substrate as the first insulation connection layer. In some other embodiments, there may be a plurality of positioning marks. The plurality of positioning marks may be all located on the first connection substrate or any first insulation connection layer; or in the plurality of positioning marks, some positioning marks are located on the first connection substrate, and the other positioning marks are stacked with the first insulation connection layers (for example, one positioning mark may be located on one first insulation connection layer, and this is not specifically limited in this embodiment).

In some embodiments, the scribe line structure includes a first sub-scribe line structure, the first sub-scribe line structure extends in a first direction, a value range of a length of the first sub-scribe line structure in a second direction is 80 micrometers to 120 micrometers, the first direction and the second direction are perpendicular to each other and are both parallel to the package substrate; and/or the scribe line structure includes a second sub-scribe line structure, the first sub-scribe line structure extends in the first direction, the second sub-scribe line structure extends in the second direction, a value range of a length of the second sub-scribe line structure in the first direction is 80 micrometers to 120 micrometers, the first direction and the second direction are perpendicular to each other and are both parallel to the package substrate. The foregoing disposing helps further reduce a spacing between adjacent first dies in the first chip structure layer, and further improves a storage capacity of the first chip structure layer.

In some embodiments, there are a plurality of first chip structure layers, the plurality of first chip structure layers are stacked in a third direction, and the third direction is perpendicular to the package substrate. Two adjacent first chip structure layers are electrically connected, so that each first chip structure layer is electrically connected to the package substrate. The plurality of first chip structure layers are disposed, to help further enhance performance of the chip integrated structure. For example, when the first die includes a memory chip, this helps increase a storage capacity of the chip integrated structure; and when the first die includes a logic chip, this helps increase a calculation processing rate of the chip integrated structure.

In some embodiments, the chip integrated structure further includes a first redistribution layer. The first redistribution layer is located between two adjacent first chip structure layers. The first redistribution layer includes a first portion and a second portion that are stacked, the first portion is electrically connected to one first chip structure layer, and the second portion is electrically connected to the other first chip structure layer. The first portion may be an upper portion in the first redistribution layer, and is configured to redistribute wiring of an upper first chip structure layer in the two adjacent first chip structure layers. Correspondingly, the second portion may be a lower portion in the first redistribution layer, and is configured to redistribute wiring of a lower first chip structure layer in the two adjacent first chip structure layers. The first portion and the second portion in the first redistribution layer are electrically connected, so that two adjacent first chip structure layers can be electrically connected through the first redistribution layer. Materials of the first portion and the second portion may include, for example, one or more conductive materials of copper, aluminum, nickel, gold, silver, titanium, cobalt, and tungsten, or another conductive alloy material.

The first redistribution layer further includes a first bonding portion and a second bonding portion. The first bonding portion is located on a side that is of the first portion and that is close to the second portion, the second bonding portion is located on a side that is of the second portion and that is close to the first portion, and the second portion is bonded with the first portion through the first bonding portion and the second bonding portion. Herein, bonding (Bonding) is a technology in which two pieces of atomically-flat homogeneous or heterogeneous semiconductor materials with clean surfaces undergo surface cleaning and activation processing and are directly bonded under a specific condition, and wafers are bonded integrally based on van der Waals force, molecular force, or even atomic force. For example, a bonding manner may be hybrid bonding (Hybrid Bonding). The first bonding portion is located on the side that is of the first portion and that is close to the second portion, and the second bonding portion is located on the side that is of the second portion and that is close to the first portion. For example, there are a plurality of first bonding portions and a plurality of second bonding portions, and the plurality of first bonding portions and the plurality of second bonding portions are disposed in one-to-one correspondence. According to the foregoing disposing, because lengths of the first bonding portion and the second bonding portion are small in the third direction. This helps reduce a spacing between adjacent first chip structure layers, facilitates arrangement of more lines, implements information transmission of more lines between the adjacent first chip structure layers to implement more functions, and further helps reduce a thickness of the chip integrated structure.

In some embodiments, a cross-sectional area of an end that is of the first bonding portion and that is close to the second portion is greater than a cross-sectional area of an end that is of the first bonding portion and that is close to the first portion; and/or a cross-sectional area of an end that is of the second bonding portion and that is close to the first portion is greater than a cross-sectional area of an end that is of the second bonding portion and that is close to the second portion. Herein, the "cross-sectional area" is a cross-sectional area of the first bonding portion and/or the second bonding portion in the first direction. According to the foregoing disposing, the end that is of the first bonding portion that is close to the second portion is in contact with the end that is of the second bonding portion and that is close to the first portion. This facilitates bonding between the first bonding portion and the second bonding portion, and ensures conductivity of the first redistribution layer.

In some embodiments, the first bonding portion includes a first connection pad and a second connection pad that are stacked, the first connection pad is closer to the first portion than the second connection pad, and a cross-sectional area of the second connection pad is greater than a cross-sectional area of the first connection pad in a direction parallel to the package substrate; and/or the second bonding portion includes a third connection pad and a fourth connection pad that are stacked, the third connection pad is closer to the second portion than the fourth connection pad, and a cross-sectional area of the fourth connection pad is greater than a cross-sectional area of the third connection pad in the direction parallel to the package substrate. Because the cross-sectional area of the second connection pad is greater than the cross-sectional area of the first connection pad, this facilitates contact of the first bonding portion with the second bonding portion through the second connection pad. Similarly, because the cross-sectional area of the fourth connection pad is greater than the cross-sectional area of the third connection pad, this facilitates contact of the second bonding portion with the first bonding portion through the fourth connection pad. The foregoing disposing facilitates contact between the second connection pad and the fourth connection pad, facilitates bonding between the first bonding portion and the second bonding portion, and ensures conductivity of the first redistribution layer.

In some embodiments, in the plurality of first chip structure layers that are stacked, the first chip structure layer that is farthest from the package substrate is a top structure layer, and the first chip structure layer located between the top structure layer and the package substrate is an intermediate structure layer. The intermediate structure layer includes a first conductive via that passes through the first die in the third direction, and the top structure layer is further electrically connected to the first conductive via of the intermediate structure layer through the redistribution layer. For example, in a first redistribution layer located between the top structure layer and the intermediate structure layer, a first portion is electrically connected to a first conductive layer in the top structure layer, and a second portion is electrically connected to the first conductive via in the intermediate structure layer. It can be learned that disposing the first conductive via can implement an electrical connection between the top structure layer and the intermediate structure layer.

In some embodiments, the chip integrated structure further includes a second chip structure layer. The second chip structure layer and the first chip structure layer are stacked, and the second chip structure layer includes a structure chip, a second die, and an isolating structure located between the structure chip and the second die. The second die includes a second substrate and a functional layer located on the second substrate, and the first chip structure layer is electrically connected to the functional layer of the second die. In some embodiments, the second chip structure layer may be located between the first chip structure layer and the package substrate. Certainly, in some other embodiments, the second chip structure layer may alternatively be located on a side that is of the first chip structure layer and that is away from the package substrate. This is not limited in this embodiment of this application. The second die is disposed, to help further enhance performance of the chip integrated structure. The structure chip is disposed, to play a support role, and help improve stability of the chip integrated structure.

In some embodiments, a material of the isolating structure includes one or a combination of silicon oxide, silicon nitride, and silicon oxynitride. The isolating structure is disposed, to implement a structure connection between the structure chip and the second die. The second chip structure layer may include a plurality of isolating structures, and the plurality of isolating structures may be synchronously manufactured. For example, after the structure chip and the second die are spaced apart, there is a gap between the structure chip and the second die, and an isolating material may be filled in the gap, to form the isolating structure.

In some embodiments, the chip integrated structure further includes a second redistribution layer. The second chip structure layer is located between the first chip structure layer and the package substrate, the second redistribution layer is located between the first chip structure layer and the second chip structure layer, the first chip structure layer and the second chip structure layer are electrically connected through the second redistribution layer, and the second chip structure layer is electrically connected to the package substrate. The second chip structure layer may be located between the first chip structure layer and the package substrate. Herein, the first chip structure layer is a first chip structure layer closest to the package substrate in the plurality of first chip structure layers. The second redistribution layer is located between the first chip structure layer and the second chip structure layer, and the first chip structure layer and the second chip structure layer are electrically connected through the second redistribution layer. A structure of the second redistribution layer may be the same as a structure of the first redistribution layer, to help improve normalization of the chip integrated structure and improve manufacturing efficiency of the chip integrated structure.

In some embodiments, the second die further includes a second conductive via that passes through the second substrate, the functional layer is closer to the package substrate than the second substrate, and the functional layer is electrically connected to the package substrate. One end of the second conductive via is electrically connected to the functional layer, and the other end of the second conductive via is electrically connected to the second redistribution layer. According to the foregoing disposing, the first die in the first chip structure layer can be electrically connected to the functional layer of the second die through the second conductive via, and further, the first conductive layer of the first die can be electrically connected to the second conductive layer in the functional layer through the second conductive via. As described in the foregoing embodiment, because the second die can be electrically connected to the package substrate through a second connecting member, and the functional layer is closer to the package substrate than the second substrate, an intermediate redistribution layer in the second connecting member can be configured to redistribute wiring of the functional layer, so that the functional layer is electrically connected to the package substrate through the second connecting member. In conclusion, the foregoing disposing can implement an electrical connection between any two of the first chip structure layer, the second chip structure layer, and the package substrate.

In some embodiments, the second die further includes a second conductive via that passes through the second substrate, the functional layer is farther away from the package substrate than the second substrate, and the functional layer is electrically connected to the second redistribution layer. One end of the second conductive via is electrically connected to the functional layer, and the other end of the second conductive via is electrically connected to the package substrate. According to the foregoing disposing, the first die in the first chip structure layer can be electrically connected to the functional layer, and further, the first conductive layer of the first die can be electrically connected to the second conductive layer of the functional layer. As described in the foregoing embodiment, because the second die can be electrically connected to the package substrate through the second connecting member, and one end of the second conductive via is electrically connected to the package substrate, the end of the second conductive via can be electrically connected to the second connecting member. Because one end of the second conductive via is electrically connected to the functional layer, one end of the second conductive via can be electrically connected to the second conductive layer of the functional layer. In conclusion, the foregoing disposing can implement an electrical connection between any two of the first chip structure layer, the second chip structure layer, and the package substrate.

In some embodiments, a third die is further included, the third die and the first chip structure layer are stacked, and the third die is electrically connected to the package substrate. For example, the third die may be located between the first chip structure layer and the second chip structure layer. Herein, the first chip structure layer is a first chip structure layer closest to the package substrate in the plurality of first chip structure layers. The third die is further electrically connected to the first chip structure layer and the second chip structure layer separately, so that the third die is electrically connected to the package substrate. The third die includes a third substrate and a third conductive layer located on a side of the third substrate. For example, a stacking manner between the third die and the first chip structure layer may be back-to-face (Back-to-Face, B2F) in which the third substrate faces the functional layer. The third die is disposed, to help further enhance performance of the chip integrated structure.

According to another aspect, a manufacturing method for a chip integrated structure is further provided, including: providing a package substrate; providing a first chip structure layer, where the first chip structure layer includes a scribe line structure and a plurality of first dies, and the scribe line structure connects the plurality of first dies and separates the plurality of first dies; and disposing the first chip structure layer on a side of the package substrate, and electrically connecting the first chip structure layer to the package substrate. In conclusion, the foregoing disposing helps reduce a spacing between adjacent first dies in the first chip structure layer, to increase a quantity of first dies per unit area in the first chip structure layer, and enhance performance of the chip integrated structure. For example, when the first die includes a memory chip, the quantity of first dies per unit area in the first chip structure layer increases, and this helps increase a storage capacity of the first chip structure layer, and further helps increase a storage capacity of the chip integrated structure. When the first die includes a logic chip, a quantity of first dies per unit area in the first chip structure layer increases, and this helps increase a computing processing rate of the first chip structure layer, and further helps increase a computing processing rate of the chip integrated structure.

In some embodiments, there are a plurality of first chip structure layers. Disposing the first chip structure layer on a side of the package substrate, and electrically connecting the first chip structure layer to the package substrate includes: sequentially stacking the plurality of first chip structure layers on the package substrate, where in the plurality of first chip structure layers, the first chip structure layer closest to the package substrate is electrically connected to the package substrate, and any two adjacent first chip structure layers are electrically connected. As described in the foregoing embodiment, adjacent first chip structure layers may be electrically connected through a first redistribution layer. In a process of sequentially stacking the plurality of first chip structure layers on the package substrate, after one first chip structure layer is disposed, one first redistribution layer may be disposed on a side that is of the first chip structure layer and that is away from the package substrate, and then the 2^{nd} first chip structure layer is disposed on a side that is of the first redistribution layer and that is away from the package substrate, ...., and so on. The foregoing disposing can implement an electrical connection between any two adjacent first chip structure layers.

In some embodiments, before disposing the first chip structure layer on a side of the package substrate, and electrically connecting the first chip structure layer to the package substrate, the method further includes: forming a second chip structure layer on a carrier; and disposing the first chip structure layer on a side that is of the second chip structure layer and that is away from the carrier, and electrically connecting the first chip structure layer to the second chip structure layer. Disposing the first chip structure layer on a side of the package substrate, and electrically connecting the first chip structure layer to the package substrate includes: removing the carrier; and electrically connecting a side that is of the second chip structure layer and that is away from the first chip structure layer to the package substrate. According to the foregoing steps, the package substrate, the second chip structure layer, and the first chip structure layer can be stacked and electrically connected, to form the chip integrated structure.

In some embodiments, forming the second chip structure layer on the carrier includes: selecting a structure chip from a first wafer, and disposing the selected structure chip on the carrier; selecting a second die from a second wafer, and disposing the selected second die on the carrier; and forming an isolating structure between the structure chip and the second die, where the structure chip, the second die, and the isolating structure jointly form the second chip structure layer. According to the foregoing disposing, the second chip structure layer may be formed on the carrier, to enhance performance of the chip integrated structure.

In some embodiments, before disposing the first chip structure layer on a side of the package substrate, and electrically connecting the first chip structure layer to the package substrate, the method further includes: forming a second chip structure layer on the first chip structure layer, and electrically connecting the first chip structure layer to the second chip structure layer. Disposing the first chip structure layer on a side of the package substrate, and electrically connecting the first chip structure layer to the package substrate further includes: electrically connecting a side that is of the second chip structure layer and that is away from the first chip structure layer to the package substrate. According to the foregoing steps, the package substrate, the second chip structure layer, and the first chip structure layer can be stacked and electrically connected, to form the chip integrated structure.

In some embodiments, forming the second chip structure layer on the first chip structure layer, and electrically connecting the first chip structure layer to the second chip structure layer includes: selecting a structure chip from a first wafer, and disposing the selected structure chip on the first chip structure layer, so that the structure chip is connected to the first chip structure layer; selecting a second die from a second wafer, and disposing the selected second die on the first chip structure layer, so that the second die is electrically connected to the first chip structure layer; and forming an isolating structure between the structure chip and the second die, where the structure chip, the second die, and the isolating structure jointly form the second chip structure layer. According to the foregoing disposing, the second chip structure layer may be formed on the first chip structure layer, to enhance performance of the chip integrated structure.

According to still another aspect, an electronic device is further provided, including a printed circuit board and the chip integrated structure in the foregoing embodiment. The chip integrated structure is electrically connected to the printed circuit board.

The electronic device provided in this embodiment of this application includes the foregoing chip integrated structure, and therefore has all the foregoing beneficial effects. Details are not described herein again.

### BRIEF DESCRIPTION OF DRAWINGS

FIG. 1 is a diagram of a structure of an electronic device according to an embodiment of this application;
FIG. 2 is a diagram of a current structure of a chip stacking structure according to some embodiments;
FIG. 3 is a diagram of a current structure of a chip wafer according to some embodiments;
FIG. 4 is a diagram of a structure of a chip integrated structure according to an embodiment of this application;
FIG. 5 is a top view of a first chip structure layer according to an embodiment of this application;
FIG. 6 is a diagram of a structure of a wafer according to an embodiment of this application;
FIG. 7 is a sectional view of a first chip structure layer according to an embodiment of this application;
FIG. 8 is a sectional view of the first chip structure layer in FIG. 7 along a section line S1-S2;
FIG. 9 is a sectional view of a first chip structure layer according to an embodiment of this application;
FIG. 10 is a top view of another first chip structure layer according to an embodiment of this application;
FIG. 11 is a diagram of a structure of another chip integrated structure according to an embodiment of this application;
FIG. 12 is a diagram of a structure of another chip integrated structure according to an embodiment of this application;
FIG. 13 is a diagram of a structure of still another chip integrated structure according to an embodiment of this application;
FIG. 14 is a diagram of a structure of yet another chip integrated structure according to an embodiment of this application;
FIG. 15 is a flowchart of steps of a manufacturing method for a chip integrated structure according to an embodiment of this application;
FIG. 16 is a flowchart of steps of another manufacturing method for a chip integrated structure according to an embodiment of this application;
FIG. 17 is a diagram of a structure of a manufacturing process in the manufacturing method for a chip integrated structure in FIG. 16;
FIG. 18 is a flowchart of steps of another manufacturing method for a chip integrated structure according to an embodiment of this application; and
FIG. 19 is a diagram of a structure of the chip integrated structure in a manufacturing process in the manufacturing method of the chip integrated structure in FIG. 18.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms such as "first" and "second", below are merely for convenience of description, and are not to be construed as indicating or implying relative importance or implicitly indicating a quantity of indicated technical features. Therefore, a feature limited by "first", "second", or the like may explicitly or implicitly include one or more features. In the descriptions of this application, unless otherwise stated, "a plurality of" means two or more than two.

In the embodiments of this application, unless otherwise specified and limited, the term "electrical connection" may be direct electrical connection, or may be indirect electrical connection through an intermediate medium.

In addition, in embodiments of this application, the word "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the term such as "example" or "for example" is intended to present a relative concept in a specific manner.

In embodiments of this application, "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects.

In embodiments of this application, for example, on, under, left, right, front, and rear are relative direction indications used to explain structures and movement of different parts in this application. These indications are appropriate when the parts are at locations shown in the figure. However, if descriptions of the locations of the parts change, these direction indications correspondingly change.

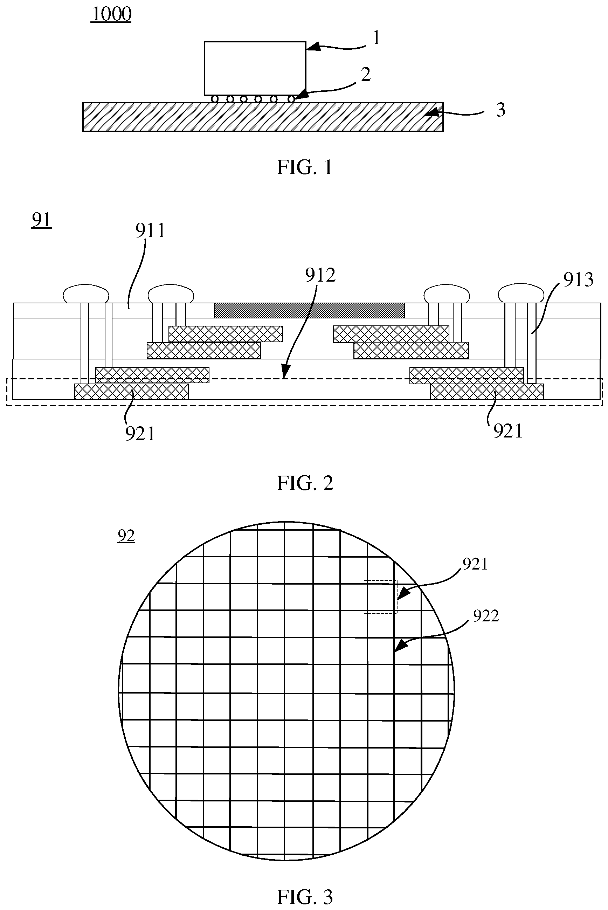

FIG. 1 is a diagram of a structure of an electronic device according to an embodiment of this application. The electronic device 1000 may include an electronic product such as an image sensor, a NAND flash, a high bandwidth memory, a mobile phone (mobile phone), a tablet computer (pad), a television, a smart wearable product (for example, a smart watch or a smart band), a virtual reality (virtual reality, VR) terminal device, or an augmented reality (augmented reality, AR) terminal device. A specific form of the electronic device 1000 is not specially limited in embodiments of this application.

The electronic device 1000 may include a printed circuit board (printed circuit board, PCB) 3, a chip integrated structure 1, and a first connecting member 2 disposed between the printed circuit board 3 and the chip integrated structure 1. The chip integrated structure 1 is electrically connected to the printed circuit board 3 through the first connecting member 2. The first connecting member 2 may be, for example, a ball grid array (ball grid array, BGA).

FIG. 2 is a diagram of a current structure of a chip stacking structure 91 according to some embodiments. As shown in FIG. 2, the chip stacking structure 91 includes a package substrate (substrate) 911 and a plurality of stacking layers 912. The plurality of stacking layers 912 are stacked on a side of the package substrate 911, and any stacking layer 912 is electrically connected to the package substrate 911. Each stacking layer 912 may include a plurality of chips 921. A conductive pillar 913 is disposed on a side that is of each chip 921 and that is close to the package substrate 911. The chip 921 is electrically connected to the package substrate 911 through the corresponding conductive pillar 913.

FIG. 3 is a diagram of a current structure of a chip wafer 92 according to some embodiments. As shown in FIG. 3, in a manufacturing process of the chip stacking structure 91, functional chips 921 need to be selected from the chip wafer 92, and are spaced apart, to form a stacking layer. It may be understood that the chip wafer 92 is formed after an epitaxial layer is grown on a wafer (wafer). The chip wafer 92 includes a scribe line structure 922 and chips 921, and the scribe line structure 922 separates the plurality of chips 921. During dicing of the chip wafer 92, a laser illuminates the scribe line structure 922, and heats the scribe line structure 922, to draw dicing grooves in the scribe line structure 922. This facilitates separation between the functional chips. A required chip 921 may be obtained through the foregoing process steps, and the chip 921 is a die (die).

However, the stacking layer 912 is formed through selection, and a spacing between adjacent chips 921 in the same stacking layer 912 is large. As a result, a quantity of chips 921 disposed per unit area in the same stacking layer 912 is reduced, and performance of the stacking layer 912 is poor. For example, when the chip 921 is a storage capacity, a storage capacity per unit area in the same stacking layer 912 is small. When the chip 921 is a logic chip (logic), a computing processing capability per unit area in the same stacking layer is reduced. In addition, the stacking layer 912 is formed through selection, and a plurality of times of dicing need to be performed to obtain the plurality of chips 921. A manufacturing process is complex, and processing efficiency is low. Consequently, product output efficiency is also reduced.

In view of this, an embodiment of this application provides a chip integrated structure 1. The chip integrated structure 1 provided in this embodiment of this application may be applied to a central processing unit (Central Processing Unit, CPU), a graphics processing unit (graphics processing unit, GPU), an AI chip, or the like in a case of a large capacity and a high bandwidth requirement.

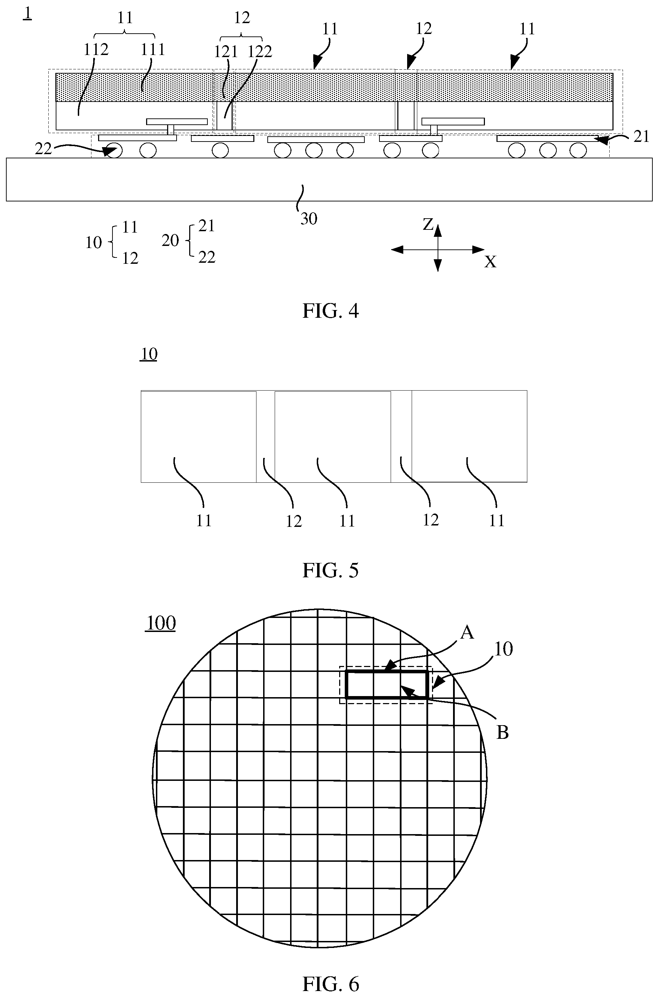

FIG. 4 is a diagram of a structure of the chip integrated structure 1 according to an embodiment of this application. As shown in FIG. 4, the chip integrated structure 1 includes a package substrate 30 and a first chip structure layer 10. The first chip structure layer 10 is located on a side of the package substrate 30, and is electrically connected to the package substrate 30.

As described in the foregoing embodiment, the chip integrated structure 1 may be electrically connected to the printed circuit board 3 through the first connecting member 2. To be specific, the package substrate 30 in the chip integrated structure 1 is electrically connected to the printed circuit board 3 through the first connecting member 2. Because the first chip structure layer 10 is electrically connected to the package substrate 30 through a second connecting member 20, and the package substrate 30 is electrically connected to the printed circuit board 3 through the first connecting member 2, communication between the chip integrated structure 1 and the electronic device 1000 can be implemented.

As shown in FIG. 4, the second connecting member 20 may be disposed between the first chip structure layer 10 and the package substrate 30, and the first chip structure may be electrically connected to the package substrate 30 through the second connecting member 20. The second connecting member 20 may include, for example, an intermediate redistribution layer 21 (Redistribution Layer, RDL). The intermediate redistribution layer 21 is located between the first chip structure layer 10 and the package substrate 30. The intermediate redistribution layer 21 is configured to redistribute wiring of the first chip structure layer 10, to facilitate manufacturing of another required structure on the intermediate redistribution layer 21. The second connecting member 20 may further include, for example, a micro bump 22 (Micro Bump, uBump). The micro bump 22 is located between the intermediate redistribution layer 21 and the package substrate 30, and the intermediate redistribution layer 21 is electrically connected to the package substrate 30 through the micro bump 22. A material of the micro bump 22 may include, for example, metal such as tin.

Still refer to FIG. 4. The first chip structure layer 10 includes a scribe line structure 12 and a plurality of first dies 11. The scribe line structure 12 connects the plurality of first dies 11 and separates the plurality of first dies 11. In this embodiment of this application, a quantity of first dies 11 in the first chip structure layer 10 is not limited, and may be set based on an application requirement. Further, in the first chip structure, sizes of the plurality of first dies 11 may be the same or may be different. This is not specifically limited in this embodiment of this application.

The first die 11 has an electrical function. Herein, the "electrical function" means that the first die 11 has a component and can be powered on to work. The first die 11 may include a digital chip, an analog chip, an optical chip, and the like. For example, the first die 11 may be a memory chip, a logic chip, or another chip with any function. The memory chip may be, for example, a dynamic random access memory (dynamic random access memory, DRAM) chip. In addition, the plurality of first dies 11 in the first chip structure layer 10 may be chips of a same type, for example, all are memory chips; or may be chips of different types. For example, chips of different types may be processed on a same wafer through corresponding processes. Based on this, the first dies 11 provided in this embodiment of this application can implement integration between chips of a same type or different types.

FIG. 5 is a top view of the first chip structure layer 10 according to an embodiment of this application. As shown in FIG. 5, the first chip structure layer 10 may include three first dies 11, the three first dies 11 are arranged in parallel, and adjacent first dies 11 are connected through the scribe line structure 12. FIG. 6 is a diagram of a structure of a wafer according to an embodiment of this application. As shown in FIG. 5 and FIG. 6, the wafer 100 includes a scribe line structure 12 and a plurality of dies (die), and the scribe line structure 12 separates the plurality of dies.

With reference to FIG. 5 and FIG. 6, the first die 11 in FIG. 5 may be obtained from the wafer 100 in FIG. 6. For example, a scribe line structure 12 at a location A in the figure is used as an example for description. Because the scribe line structure 12 at the location A is disposed around a periphery of the three adjacent dies, after dicing is performed along the scribe line structure 12 at the location A, the three adjacent dies are separated from the wafer 100, and a scribe line structure 12 (for example, a scribe line structure 12 at a location B in the figure) between the three dies is reserved. That is, the first chip structure layer 10 having the three first dies 11 in FIG. 5 is obtained. The three dies are the three first dies 11 in the first chip structure layer 10, and the scribe line structure 12 reserved between the three dies is the scribe line structure 12 in the first chip structure layer 10.

In conclusion, because the scribe line structure 12 connects the plurality of first dies 11 and separates the plurality of first dies 11, each first die 11 is one die. That is, the plurality of first dies 11 are a plurality of dies located in the same wafer 100, and adjacent dies are connected through the scribe line structure 12. In other words, dicing is not performed on a scribe line region between the plurality of first dies, and therefore a scribe line structure is reserved. The foregoing disposing helps reduce a spacing between adjacent first dies 11 in the first chip structure layer 10, to increase a quantity of first dies 11 per unit area in the first chip structure layer 10, improve integration of the chip integrated structure 1, and enhance performance of the chip integrated structure 1. For example, when the first die 11 includes a memory chip, the quantity of first dies 11 per unit area in the first chip structure layer 10 increases, and this helps increase a storage capacity of the first chip structure layer 10, and further helps increase a storage capacity of the chip integrated structure 1. When the first die 11 includes a logic chip, a quantity of first dies 11 per unit area in the first chip structure layer 10 increases, and this helps increase a computing processing rate of the first chip structure layer 10, and further helps increase a computing processing rate of the chip integrated structure 1.

In addition, because the plurality of first dies 11 are a plurality of dies located in the same wafer 100, the plurality of first dies 11 may be obtained through one time of dicing. This helps improve processing efficiency of the chip integrated structure 1, and further improves a throughput of the chip integrated structure 1 per unit time.

It may be understood that in another current common chip stacking structure, a plurality of functional chips are usually stacked. That is, each stacking layer includes one functional chip. According to the chip integrated structure 1 provided in this embodiment of this application, the scribe line structure 12 connects the plurality of first dies 11 and separates the plurality of first dies 11. In a case of a same quantity of stacking layers, the chip integrated structure 1 can achieve multiple-fold improvement in performance compared with the current chip stacking structure.

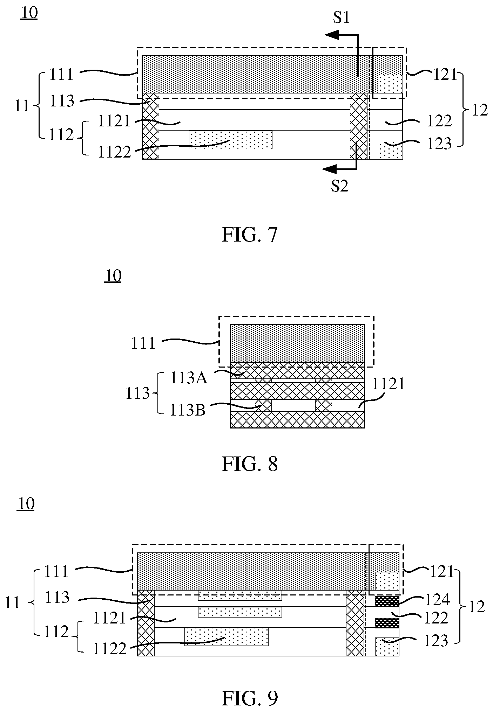

FIG. 7 is a sectional view of the first chip structure layer 10 according to an embodiment of this application. Refer to FIG. 7. The first die 11 may include a first substrate 111, and the scribe line structure 12 may include a first connection substrate 121. The first connection substrate 121 and the first substrate 111 are connected and are disposed at a same layer. For example, adjacent first substrates 111 may be connected through a first connection substrate 121. Herein, "being disposed at a same layer" means using a same film forming process to form film layers for specific patterns on the first substrate 111 and the first connection substrate 121, and then using a same mask to form layer structures through a single patterning process. The single patterning process may include a plurality of times of exposure, development, or etching processes, and the specific patterns in the formed layer structures have same materials.

Materials of the first substrate 111 and the first connection substrate 121 may be the same. For example, the first substrate 111 and the first connection substrate 121 may be made of semiconductor materials, and may be silicon substrates, gallium arsenide (GaAs) substrates, gallium arsenide phosphide (GaAsP) substrates, silicon carbide (SiC) substrates, or the like. Certainly, the first substrate 111 and the first connection substrate 121 may also be made of other materials. This is not specifically limited in this embodiment of this application.

Still refer to FIG. 7. The first die 11 may include a seal ring (seal ring) 113, the seal ring 113 is located in an edge region of the first die 11, and the seal ring 113 is adjacent to the scribe line structure 12. For example, the edge region of the first die 11 may be a region in a circumferential direction of the first die 11. That is, the seal ring 113 is disposed in a circumferential direction of the first die 11. FIG. 8 is a sectional view of the first chip structure layer 10 in FIG. 7 along a section line S1-S2. As shown in FIG. 8, the seal ring 113 includes a plurality of stacked seal layers 113A and a plurality of seal plugs 113B. One seal plug 113B is located between two adjacent seal layers 113A, and the seal plug 113B is in contact with the two adjacent seal layers 113A. It may be understood that when dicing is performed on a scribe line structure adjacent to the first die 11, stress is easily transferred to the first die 11. This causes damage in the first die 11, and further degrades performance of the first die 11. The seal ring 113 is disposed, to help reduce the stress transferred to the first die 11 to reduce damage in the first die 11, and help enhance performance of the first die 11.

Still refer to FIG. 7. The first die 11 may include a plurality of first insulation layers 1121, the plurality of first insulation layers 1121 are located on the first substrate 111, and the plurality of first insulation layers 1121 are stacked. The scribe line structure 12 includes a plurality of first insulation connection layers 122, the plurality of first insulation connection layers 122 are located on the first connection substrate 121, and the plurality of first insulation connection layers 122 are stacked. The plurality of first insulation connection layers 122 are connected to the plurality of first insulation layers 1121 in one-to-one correspondence, and a first insulation connection layer 122 and a first insulation layer 1121 that are correspondingly connected are disposed at a same layer. For example, two corresponding first insulation layers 1121 in adjacent first dies 11 are connected through a corresponding first insulation connection layer 122. Herein, "being disposed at a same layer" means using a same film forming process to form film layers for specific patterns on the first insulation layer 1121 and the first insulation connection layer 122, and then using a same mask to form layer structures through a single patterning process. The single patterning process may include a plurality of times of exposure, development, or etching processes, and the specific patterns in the formed layer structures have same materials.

Materials of the first insulation layer 1121 and the first insulation connection layer 122 may include one or a combination of silicon oxide, silicon nitride, and silicon oxynitride. Certainly, the first insulation layer 1121 and the first insulation connection layer 122 may also be made of other materials. This is not specifically limited in this embodiment of this application.

FIG. 9 is a sectional view of the first chip structure layer 10 according to an embodiment of this application. Refer to FIG. 9. The first die 11 may further include a plurality of first conductive layers 1122, the plurality of first conductive layers 1122 are located on the first substrate 111, and the plurality of first conductive layers 1122 are stacked. For example, the first conductive layers 1122 and the first insulation layers 1121 are located on a same side of the first substrate 111. As described in the foregoing embodiment, the scribe line structure 12 includes the plurality of first insulation connection layers 122, the plurality of first insulation connection layers 122 are located on the first connection substrate 121, and the plurality of first insulation connection layers 122 are stacked. A quantity of the plurality of first insulation connection layers 122 may be the same as a quantity of the plurality of first conductive layers 1122. For example, the plurality of first insulation connection layers 122 may be in one-to-one correspondence with the plurality of first conductive layers 1122, so that the quantity of the plurality of first insulation connection layers 122 is the same as the quantity of the plurality of first conductive layers 1122. The first conductive layers 1122 include a plurality of layers of metal lines, and the metal lines are configured to electrically connect a plurality of electronic components together, to form a circuit structure of the first die 11. The electronic component may include, for example, a transistor, a capacitor, and a resistor. The first conductive layers 1122 and the first insulation layers 1121 that are stacked to jointly form a functional layer 112 of the first die 11, to implement a storage, logic, or other function of the first die 11. Certainly, in some other embodiments, the quantity of the plurality of first insulation connection layers 122 may be greater than the quantity of the plurality of first conductive layers 1122, and the plurality of first conductive layers 1122 may be in one-to-one correspondence with a part of the first insulation connection layers 122. This is not limited in this embodiment of this application.

In some embodiments, with reference to FIG. 4, the first insulation layer 1121 may be closer to the package substrate 30 than the first substrate 111, and correspondingly, the first insulation connection layer 122 is closer to the package substrate 30 than the first connection substrate 121. Certainly, in some other embodiments, correspondingly, the first insulation layer 1121 may be farther away from the package substrate 30 than the first substrate 111, and the first insulation connection layer 122 is farther away from the package substrate 30 than the first connection substrate 121.

Refer to FIG. 7. The scribe line structure 12 may include a positioning mark 123. For example, the first connection substrate 121 may be provided with at least one positioning mark 123. In some embodiments, there may be only one positioning mark 123. The positioning mark 123 may be provided on the first connection substrate 121, and is located between the first connection substrate 121 and the first insulation connection layer 122. In some other embodiments, there may be a plurality of positioning marks 123. The plurality of positioning marks 123 may be all located on the first connection substrate 121. The first connection substrate 121 is provided with the at least one positioning mark 123, and the positioning mark 123 may play a positioning role in a process of manufacturing the first insulation layer 1121 and the first insulation connection layer 122.

Refer to FIG. 7. For example, at least one first insulation connection layer 122 may be provided with at least one positioning mark 123. In some embodiments, there may be only one positioning mark 123. The positioning mark 123 is located on the first insulation connection layer 122, and is located on a same side of the first connection substrate 121 as the first insulation connection layer 122. In some other embodiments, there may be a plurality of positioning marks 123. The plurality of positioning marks 123 may be located on the first connection substrate 121 or any first insulation connection layer 122. Herein, the positioning mark 123 may play a positioning role in a process of manufacturing the first insulation layer 1121 and the first insulation connection layer 122.

In some other embodiments, in the plurality of positioning marks 123, some positioning marks 123 are located on the first connection substrate 121, and the other positioning marks 123 are located on the first insulation connection layer 122 (for example, one positioning mark 123 may be located at one first insulation connection layer 122, and this is not specifically limited in this embodiment of this application).

Still refer to FIG. 9. The scribe line structure 12 includes a plurality of metal layers 124, the plurality of metal layers 124 are located on the first connection substrate 121, and the plurality of metal layers 124 are stacked. The plurality of metal layers 124 are in one-to-one correspondence with a part of the plurality of first conductive layers 1122, and a metal layer 124 and a first conductive layer 1122 that are in correspondence are disposed at a same layer and are electrically isolated from each other. For example, the plurality of metal layers 124 may be disposed on the first insulation connection layer 122, and the plurality of metal layers 124 may be stacked, and are located on a same side of the first connection substrate 121 as the first insulation connection layer 122. The plurality of metal layers 124 are in one-to-one correspondence with a part of the plurality of first conductive layers 1122 without contact, so that a metal layer 124 and a first conductive layer 1122 that are in correspondence are electrically isolated from each other. Herein, "being disposed at a same layer" means using a same film forming process to form film layers for specific patterns on the metal layer 124 and the first conductive layer 1122, and then using a same mask to form layer structures through a single patterning process. The single patterning process may include a plurality of times of exposure, development, or etching processes, and the specific patterns in the formed layer structures have same materials.

In some embodiments, at least a part of the plurality of metal layers 124 form a test structure. Herein, the test structure (Testkey) is tested by using a specific test machine, to reflect a process fluctuation in a manufacturing process of the first die 11 and detect whether an exception occurs in a manufacturing line.

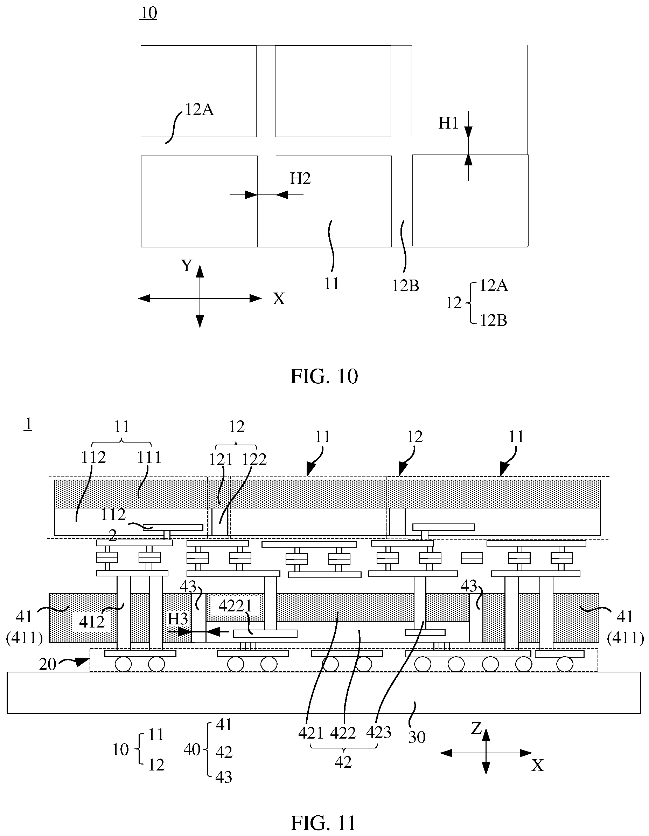

FIG. 10 is a top view of another first chip structure layer 10 according to an embodiment of this application. As shown in FIG. 10, the scribe line structure 12 may include a first sub-scribe line structure 12A. The first sub-scribe line structure 12A extends in a first direction X, and is parallel to the package substrate 30. In some embodiments, a value range of a length H1 of the first sub-scribe line structure 12A in a second direction Y may be 80 micrometers to 120 micrometers. For example, the length H1 of the first sub-scribe line structure 12A in the second direction Y may be 80 micrometers, 90 micrometers, or 120 micrometers.

As shown in FIG. 10, the scribe line structure 12 may include a second sub-scribe line structure 12B. The second sub-scribe line structure 12B extends along the second direction Y. The first direction X and the second direction Y are perpendicular to each other and are both parallel to the package substrate 30. A value range of a length H2 of the second sub-scribe line structure 12B in the first direction X may be 80 micrometers to 120 micrometers. For example, the length H2 of the second sub-scribe line structure 12B in the first direction X may be 80 micrometers, 90 micrometers, or 120 micrometers.

Certainly, in some other embodiments, the length H1 of the first sub-scribe line structure 12A in the second direction Y may be further greater than 120 micrometers, and the length H2 of the second sub-scribe line structure 12B in the first direction X may be further greater than 120 micrometers. This is not specifically limited in this embodiment of this application.

For example, the first chip structure layer 10 may include six first dies 11, and the six first dies 11 are arranged in an array. Correspondingly, the scribe line structure 12 may include one first sub-scribe line structure 12A extending in the first direction X and two second sub-scribe line structures 12B extending in the second direction Y. The foregoing disposing helps further reduce a spacing between adjacent first dies 11 in the first chip structure layer 10, and further improves a storage capacity of the first chip structure layer 10.

FIG. 11 is a diagram of a structure of another chip integrated structure 1 according to an embodiment of this application. As shown in FIG. 11, the chip integrated structure 1 may further include a second chip structure layer 40, the second chip structure layer 40 and the first chip structure layer 10 are stacked, and the second chip structure layer 40 is electrically connected to the package substrate 30. In some embodiments, the second chip structure layer 40 may be located between the first chip structure layer 10 and the package substrate 30. Certainly, in some other embodiments, the second chip structure layer 40 may alternatively be located on a side that is of the first chip structure layer 10 and that is away from the package substrate 30. This is not limited in this embodiment of this application. The second chip structure is disposed, to help further enhance performance of the chip integrated structure 1. The following describes only an embodiment in which the second chip structure layer 40 is located between the first chip structure layer 10 and the package substrate 30.

Still refer to FIG. 11. A second connecting member 20 may be located between the second chip structure layer 40 and the package substrate 30, and the first chip structure layer 10 is electrically connected to the second connecting member 20 through the second chip structure layer 40. Because the second connecting member 20 is further electrically connected to the package substrate 30, the first chip structure layer 10 can be electrically connected to the package substrate 30 through the second chip structure layer 40 and the second connecting member 20.

Still refer to FIG. 11. The second chip structure layer 40 may include a structure chip 41, a second die 42, and an isolating structure 43 located between the structure chip 41 and the second die 42. For example, the second chip structure may include one second die 42 and two structure chips 41. The two structure chips 41 are respectively located on the left and the right of a location of the second die 42 shown in the figure, and the second die 42 is connected to the structure chips 41 through the isolating structure 43.

The structure chip 41 may include a structure substrate 411. A material of the structure substrate 411 may be the same as a material of the first substrate 111, and details are not described herein again. Certainly, the material of the structure substrate 411 may be different from the material of the first substrate 111. This is not limited in this embodiment of this application. The structure chip 41 is disposed, to play a support role, and help improve stability of the chip integrated structure 1. Certainly, in some other embodiments, a quantity of structure chips 41 may be set according to an actual requirement, or the structure chip 41 may be omitted.

In some embodiments, the structure chip 41 may further include an intermediate conductive via 412 that passes through the structure substrate 411. One end of the intermediate conductive via 412 is electrically connected to the first conductive layer 1122 of the first die 11, and the other end of the intermediate conductive via 412 is electrically connected to the second connecting member 20, so that the first conductive layer 1122 of the first die 11 can be electrically connected to the second connecting member 20 through the structure chip 41, and further electrically connected to the package substrate 30. The intermediate conductive via 412 may be a through silicon via (TSV, Through Silicon Via), or may be a via of another material, and may be filled with a conductive material to ensure a conductive function.

The isolating structure 43 is disposed, to implement a structure connection between the structure chip 41 and the second die 42. The second chip structure layer 40 may include a plurality of isolating structures 43, and the plurality of isolating structures 43 may be synchronously manufactured. For example, after the structure chip 41 and the second die 42 are spaced apart, there is a gap between the structure chip 41 and the second die 42, and an isolating material may be filled in the gap, to form the isolating structure 43. A material of the isolating structure 43 may include, for example, one or a combination of silicon oxide, silicon nitride, and silicon oxynitride. Certainly, the material of the isolating structure 43 may further include another material, to implement electrical isolating effect. This is not specifically limited in this embodiment of this application.

In some embodiments, a length H3 of the isolating structure 43 in the first direction X may be greater than 50 micrometers. For example, the length H3 of the isolating structure 43 in the first direction may be 50 micrometers, 100 micrometers, or 150 micrometers. The foregoing disposing helps reduce a spacing between the second die 42 and the structure chip 41, to further reduce a size of the second chip structure layer 40, and further enhance performance of the chip integrated structure 1.

Herein, a type of the second die 42 is not limited, and the type of the second die 42 may be the same as a type of the first die 11, or the type of the second die 42 may be different from the type of the first die 11. As described in the foregoing embodiment, the second die 42 has an electrical function. Herein, the "electrical function" means that the second die 42 has a component and can be powered on to work. The second die 42 may include a digital chip, an analog chip, an optical chip, and the like, for example, may be a memory chip, a logic chip, or a chip with any other function. This is not specifically limited in this embodiment of this application.

The second die 42 may include a second substrate 421 and a functional layer 422 located on the second substrate 421, and the first chip structure layer 10 is electrically connected to the functional layer 422 of the second die 42. A material of the second substrate 421 may include one or a combination of silicon oxide, silicon nitride, and silicon oxynitride. The functional layer 422 may include a second conductive layer 4221, the second conductive layer 4221 includes a plurality of layers of metal lines, and the metal lines are configured to electrically connect a plurality of electronic components together, to form a circuit structure of the second die 42. For example, the first conductive layer 1122 of the first die 11 in the first chip structure layer 10 may be electrically connected to the second conductive layer 4221 of the second die 42, and the second die 42 is further electrically connected to the package substrate 30, so that the package substrate 30 communicates with the first die 11 and the second die 42 separately. As described in the foregoing embodiment, because the second chip structure layer 40 can be electrically connected to the package substrate 30 through the second connecting member 20, the second die 42 in the second chip structure layer 40 can be electrically connected to the package substrate 30 through the second connecting member 20.

Still refer to FIG. 11. The second die 42 may further include a second conductive via 423 that passes through the second substrate 421. In some implementations, the functional layer 422 is closer to the package substrate 30 than the second substrate 421, and the functional layer 422 is electrically connected to the package substrate 30. For example, the second conductive via 423 may pass through the second substrate 421 in a third direction Z, and the third direction Z is perpendicular to the package substrate 30. One end of the second conductive via 423 is electrically connected to the functional layer 422, and the other end of the second conductive via 423 is electrically connected to the first chip structure layer 10.

According to the foregoing disposing, the first die 11 in the first chip structure layer 10 can be electrically connected to the functional layer 422 of the second die 42 through the second conductive via 423, and further, the first conductive layer 1122 of the first die 11 can be electrically connected to the second conductive layer 4221 in the functional layer 422 through the second conductive via 423. As described in the foregoing embodiment, because the second die 42 can be electrically connected to the package substrate 30 through the second connecting member 20, and the functional layer 422 is closer to the package substrate 30 than the second substrate 421, the intermediate redistribution layer 21 in the second connecting member 20 can be configured to redistribute wiring of the functional layer 422, so that the functional layer 422 is electrically connected to the package substrate 30 through the second connecting member 20. In conclusion, the foregoing disposing can implement an electrical connection between any two of the first chip structure layer 10, the second chip structure layer 40, and the package substrate 30.

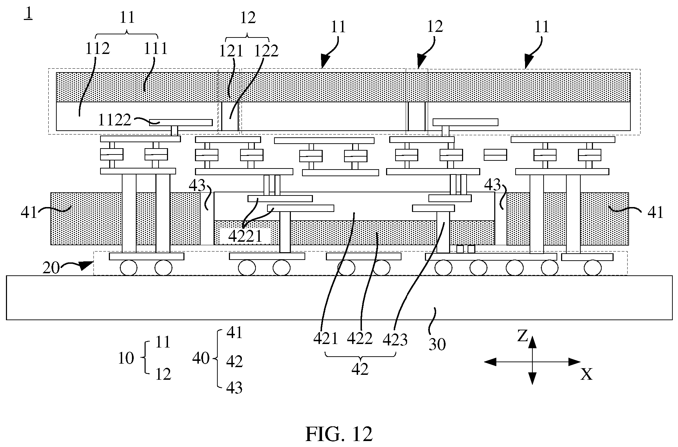

FIG. 12 is a diagram of a structure of another chip integrated structure 1 according to an embodiment of this application. As shown in FIG. 12, in some other implementations, the functional layer 422 is farther away from the package substrate 30 than the second substrate 421, and the functional layer 422 is electrically connected to the first chip structure layer 10. One end of the second conductive via 423 is electrically connected to the functional layer 422, and the other end of the second conductive via 423 is electrically connected to the package substrate 30. According to the foregoing disposing, the first die 11 in the first chip structure layer 10 can be electrically connected to the functional layer 422, and further, the first conductive layer 1122 of the first die 11 can be electrically connected to the second conductive layer 4221 of the functional layer 422. As described in the foregoing embodiment, because the second die 42 can be electrically connected to the package substrate 30 through the second connecting member 20, and one end of the second conductive via 423 is electrically connected to the package substrate 30, the end of the second conductive via 423 can be electrically connected to the second connecting member 20. Because one end of the second conductive via 423 is electrically connected to the functional layer 422, one end of the second conductive via 423 can be electrically connected to the second conductive layer 1122 of the functional layer 422. In conclusion, the foregoing disposing can implement an electrical connection between any two of the first chip structure layer 10, the second chip structure layer 40, and the package substrate 30.

Herein, the second conductive via 423 may be a through silicon via (TSV, Through Silicon Via), or may be a via of another material, and may be filled with a conductive material to ensure a conductive function.

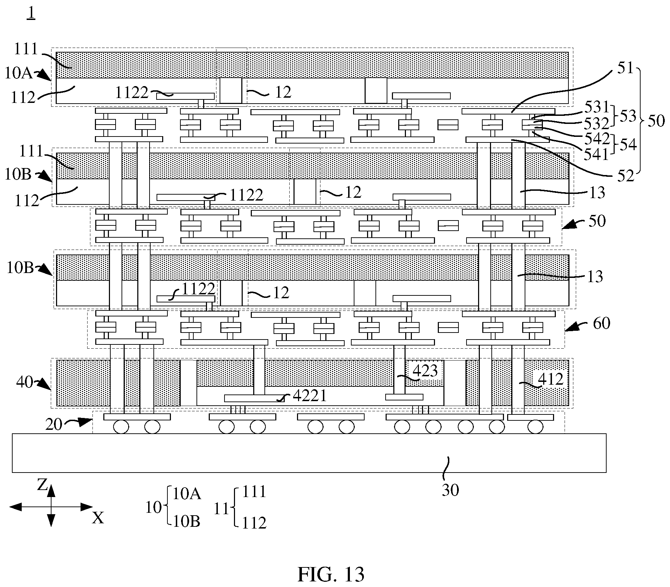

FIG. 13 is a diagram of a structure of still another chip integrated structure 1 according to an embodiment of this application. As shown in FIG. 13, there may be a plurality of first chip structure layers 10, the plurality of first chip structure layers 10 may be stacked in the third direction Z, and the third direction Z is perpendicular to the package substrate 30. Two adjacent first chip structure layers 10 are electrically connected, so that each first chip structure layer 10 is electrically connected to the package substrate 30. The plurality of first chip structure layers 10 are disposed, to help further enhance performance of the chip integrated structure 1. For example, when the first die 11 includes a memory chip, this helps increase a storage capacity of the chip integrated structure 1; and when the first die 11 includes a logic chip, this helps increase a calculation processing rate of the chip integrated structure 1.

In some embodiments, in the plurality of stacked first chip structure layers 10, a stacking manner between two adjacent first chip structure layers 10 may be face-to-face (Face-to-Face, F2F) in which a functional layer 112 faces a functional layer 112, and a stacking manner between the remaining two adjacent first chip structure layers 10 may be back-to-back (Back-to-Back, B2B) in which a first substrate 111 faces a first substrate 111.

In some other embodiments, in the plurality of stacked first chip structure layers 10, a stacking manner between two adjacent first chip structure layers 10 is back-to-face (Back-to-Face, B2F) in which a first substrate 111 faces a functional layer 112. For example, as shown in FIG. 13, a functional layer 112 in any first chip structure layer 10 may be closer to the package substrate 30 than a first substrate 111. Certainly, in another example, a functional layer 112 in any first chip structure layer 10 may be farther away from the package substrate 30 than a first substrate 111. This is not specifically limited in this embodiment of this application.

In the plurality of stacked first chip structure layers 10, quantities of first dies 11 in the plurality of first chip structure layers 10 may be the same or may be different. This is not specifically limited in this embodiment of this application. Further, scribe line structures 12 in the plurality of first chip structure layers 10 may be staggered in the third direction Z, or the scribe line structures 12 in the plurality of first chip structure layers 10 may sequentially overlap in the third direction Z. This is not specifically limited in this embodiment of this application.

Still refer to FIG. 13. The chip integrated structure 1 may further include a first redistribution layer 50, and the first redistribution layer 50 is located between two adjacent first chip structure layers 10. The first redistribution layer 50 includes a first portion 51 and a second portion 52 that are stacked, the first portion 51 is electrically connected to one first chip structure layer 10, and the second portion 52 is electrically connected to the other first chip structure layer 10. For example, the first portion 51 may be an upper portion in the first redistribution layer 50 in the figure, and is configured to redistribute wiring of an upper first chip structure layer 10 in the two adjacent first chip structure layers 10 in the figure. Correspondingly, the second portion 52 may be a lower portion in the first redistribution layer 50 in the figure, and is configured to redistribute wiring of a lower first chip structure layer 10 in the two adjacent first chip structure layers 10 in the figure. The first portion 51 and the second portion 52 in the first redistribution layer 50 are electrically connected, so that two adjacent first chip structure layers 10 can be electrically connected through the first redistribution layer 50. Compared with a current case in which the stacking layer 912 is directly connected to the package substrate 911 through the conductive pillar 913, the first redistribution layer 50 may be disposed to implement transfer between the plurality of first chip structure layers 10, so that the plurality of first chip structure layers 10 are electrically connected to the package substrate 30. This helps reduce a connection line distance between the first chip structure layer 10 and the package substrate 30, and enhance performance of the chip integrated structure.

Materials of the first portion 51 and the second portion 52 may include, for example, one or more conductive materials of copper, aluminum, nickel, gold, silver, titanium, cobalt, and tungsten, or another conductive alloy material.

Still refer to FIG. 13. The first redistribution layer 50 further includes a first bonding portion 53 and a second bonding portion 54, and the second portion 52 and the first portion 51 may be bonded through the first bonding portion 53 and the second bonding portion 54. Herein, bonding (Bonding) is a technology in which two pieces of atomically-flat homogeneous or heterogeneous semiconductor materials with clean surfaces undergo surface cleaning and activation processing and are directly bonded under a specific condition, and wafers are bonded integrally based on van der Waals force, molecular force, or even atomic force. For example, a bonding manner may be hybrid bonding (Hybrid Bonding). The first bonding portion 53 is located on a side that is of the first portion 51 and that is close to the second portion 52, and the second bonding portion 54 is located on a side that is of the second portion 52 and that is close to the first portion 51. For example, there are a plurality of first bonding portions 53 and a plurality of second bonding portions 54, and the plurality of first bonding portions 53 and the plurality of second bonding portions 54 are disposed in one-to-one correspondence. According to the foregoing disposing, because lengths of the first bonding portion 53 and the second bonding portion 54 are small in the third direction Z. This helps reduce a spacing between adjacent first chip structure layers 10, facilitates arrangement of more lines, implements information transmission of more lines between the adjacent first chip structure layers 10 to implement more functions, and further helps reduce a thickness of the chip integrated structure 1.

Still refer to FIG. 13. A cross-sectional area of an end that is of the first bonding portion 53 and that is close to the second portion 52 may be greater than a cross-sectional area of an end that is of the first bonding portion 53 and that is close to the first portion 51. Herein, the "cross-sectional area" is a cross-sectional area of the first bonding portion 53 in the first direction X. A cross-sectional area of an end that is of the second bonding portion 54 and that is close to the first portion 51 may be greater than a cross-sectional area of an end that is of the second bonding portion 54 and that is close to the second portion 52. Herein, the "cross-sectional area" is a cross-sectional area of the second bonding portion 54 in the first direction X. According to the foregoing disposing, the end that is of the first bonding portion 53 that is close to the second portion 52 is in contact with the end that is of the second bonding portion 54 and that is close to the first portion 51. This facilitates bonding between the first bonding portion 53 and the second bonding portion 54, and ensures conductivity of the first redistribution layer 50.

Still refer to FIG. 13. The first bonding portion 53 may include a first connection pad 531 and a second connection pad 532 that are stacked. The first connection pad 531 is closer to the first portion 51 than the second connection pad 532. A cross-sectional area of the second connection pad 532 is greater than a cross-sectional area of the first connection pad 531 in a direction parallel to the package substrate 30. For example, the direction parallel to the package substrate 30 is the first direction X shown in the figure. Because the cross-sectional area of the second connection pad 532 is greater than the cross-sectional area of the first connection pad 531, this facilitates contact of the first bonding portion 53 with the second bonding portion 54 through the second connection pad 532.

Still refer to FIG. 13. The second bonding portion 54 may include a third connection pad 541 and a fourth connection pad 542 that are stacked. The third connection pad 541 is closer to the second portion 52 than the fourth connection pad 542. A cross-sectional area of the fourth connection pad 542 is greater than a cross-sectional area of the third connection pad 541 in the direction parallel to the package substrate 30. For example, the direction parallel to the package substrate 30 is the first direction X shown in the figure. Because the cross-sectional area of the fourth connection pad 542 is greater than the cross-sectional area of the third connection pad 541, this facilitates contact of the second bonding portion 54 with the first bonding portion 53 through the fourth connection pad 542. The foregoing disposing facilitates contact between the second connection pad 532 and the fourth connection pad 542, facilitates bonding between the first bonding portion 53 and the second bonding portion 54, and ensures conductivity of the first redistribution layer 50.

Certainly, in some other examples, the first redistribution layer 50 may further include a micro bump 22, and the micro bump 22 is located between the first portion 51 and the second portion 52, so that the first portion 51 and the second portion 52 are electrically connected through the micro bump 22.

Still refer to FIG. 13. The plurality of first chip structure layers 10 may be located on a side that is of the second chip structure layer 40 and that is away from the package substrate 30. In the plurality of stacked first chip structure layers 10, a first chip structure layer 10 that is farthest from the package substrate 30 may be a top structure layer 10A, and a first chip structure layer 10 located between the top structure layer 10A and the package substrate 30 may be an intermediate structure layer 10B. The intermediate structure layer 10B may include a first conductive via 13 that passes through the first die 11 in the third direction Z, and the top structure layer 10A may be further electrically connected to the first conductive via 13 of the intermediate structure layer 10B.

For example, in a first redistribution layer 50 located between the top structure layer 10A and the intermediate structure layer 10B, a first portion 51 is electrically connected to a first conductive layer 1122 in the top structure layer 10A, and a second portion 52 is electrically connected to the first conductive via 13 in the intermediate structure layer 10B. It can be learned that disposing the first conductive via 13 can implement an electrical connection between the top structure layer 10A and the intermediate structure layer 10B.

For example, in a first redistribution layer 50 located between adjacent intermediate structure layers 10B, a first portion 51 is electrically connected to a first conductive via 13 of an upper intermediate structure layer 10B shown in the figure, the first portion 51 is further electrically connected to a first conductive layer 1122 of the upper intermediate structure layer 10B shown in the figure, and a second portion 52 is electrically connected to a first conductive via 13 of a lower intermediate structure layer 10B shown in the figure. It can be learned that disposing the first conductive via 13 can further implement an electrical connection between adjacent intermediate structure layers 10B, and the top structure layer 10A can be further electrically connected to any intermediate structure layer 10B through a plurality of first conductive vias 13.

Still refer to FIG. 13. The chip integrated structure 1 may further include a second redistribution layer 60. As described in the foregoing embodiment, the second chip structure layer 40 may be located between the first chip structure layer 10 and the package substrate 30. Herein, the first chip structure layer 10 is a first chip structure layer 10 closest to the package substrate 30 in the plurality of first chip structure layers 10. The second redistribution layer 60 is located between the first chip structure layer 10 and the second chip structure layer 40, and the first chip structure layer 10 and the second chip structure layer 40 are electrically connected through the second redistribution layer 60.

In some embodiments, a structure of the second redistribution layer 60 may be the same as a structure of the first redistribution layer 50, to help improve normalization of the chip integrated structure 1 and improve manufacturing efficiency of the chip integrated structure 1.

For example, a side that is of the second redistribution layer 60 and that is close to the first chip structure layer 10 is electrically connected to the first conductive via 13. A side that is of the second redistribution layer 60 in the structure layer and that is close to the second chip structure layer 40 is electrically connected to an intermediate conductive via 412 and the second die 42. In an embodiment in which the functional layer 422 in the second die 42 is closer to the package substrate 30 than the second substrate 421, the functional layer 422 is electrically connected to the package substrate 30, one end of the second conductive via 423 is electrically connected to the functional layer 422, and the other end of the second conductive via 423 is electrically connected to the second redistribution layer 60. In an embodiment in which the functional layer 422 in the second die 42 is farther away from the package substrate 30 than the second substrate 421, the functional layer 422 is electrically connected to the second redistribution layer 60, one end of the second conductive via 423 is electrically connected to the functional layer 422, and the other end of the second conductive via 423 is electrically connected to the package substrate 30. According to the foregoing disposing, the first chip structure layer 10 can be electrically connected to the second chip structure layer 40 through the second redistribution layer 60.

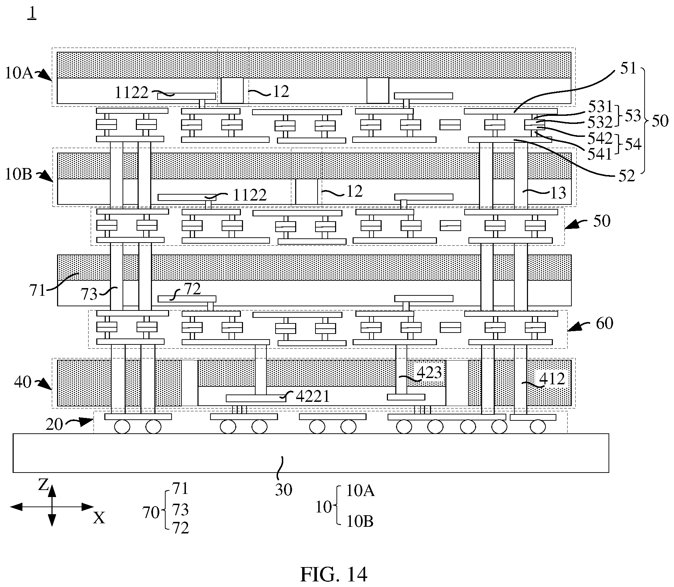

FIG. 14 is a diagram of a structure of yet another chip integrated structure 1 according to an embodiment of this application. As shown in FIG. 14, the chip integrated structure 1 may further include a third die 70. The third die 70 may be stacked with the first chip structure layer 10, and the third die 70 is electrically connected to the package substrate 30. For example, the third die 70 may be located between the first chip structure layer 10 and the second chip structure layer 40. Herein, the first chip structure layer 10 is a first chip structure layer 10 closest to the package substrate 30 in the plurality of first chip structure layers 10. The third die 70 is further electrically connected to the first chip structure layer 10 and the second chip structure layer 40 separately, so that the third die 70 is electrically connected to the package substrate 30. The third die 70 includes a third substrate 71 and a third conductive layer 72 located on a side of the third substrate 71. For example, a stacking manner between the third die 70 and the first chip structure layer 10 may be back-to-face (Back-to-Face, B2F) in which the third substrate 71 faces the functional layer 112. The third die 70 is disposed, to help further enhance performance of the chip integrated structure 1.

Herein, a type of the third die 70 is not limited, and the type of the third die 70 may be the same as the type of the first die 11, or the type of the third die 70 may be different from the type of the first die 11. As described in the foregoing embodiment, the third die 70 has an electrical function. Herein, the "electrical function" means that the third die 70 has a component and can be powered on to work. The third die 70 may include a digital chip, an analog chip, an optical chip, and the like, for example, may be a memory chip, a logic chip, or a chip with any other function. This is not specifically limited in this embodiment of this application.

The first redistribution layer 50 may also be located between the third die 70 and the first chip structure layer 10, and the third die 70 may be electrically connected to the first chip structure layer 10 through the first redistribution layer 50. The second redistribution layer 60 may also be located between the third die 70 and the second chip structure layer 40, and the third die 70 may be electrically connected to the second chip structure layer 40 through the second redistribution layer 60. For example, the third die 70 may further include a third conductive via 73 that passes through the third die 70 in the third direction Z, one end of the third conductive via 73 is electrically connected to the first redistribution layer 50, and the other end of the third conductive via 423 is electrically connected to the second redistribution layer 60. The third conductive via 73 may be a through silicon via (TSV, Through Silicon Via), or may be a via of another material, and may be filled with a conductive material to ensure a conductive function.

Certainly, in some other embodiments, the third die 70 may be further located between two adjacent first chip structure layers 10, or located on a side that is of the first chip structure layer 10 and that is away from the package substrate 30 (the first chip structure layer 10 herein is a first chip structure layer 10 that is farthest from the package substrate 30 in the plurality of first chip structure layers 10). A location of the third die 70 is not specifically limited in this embodiment of this application.

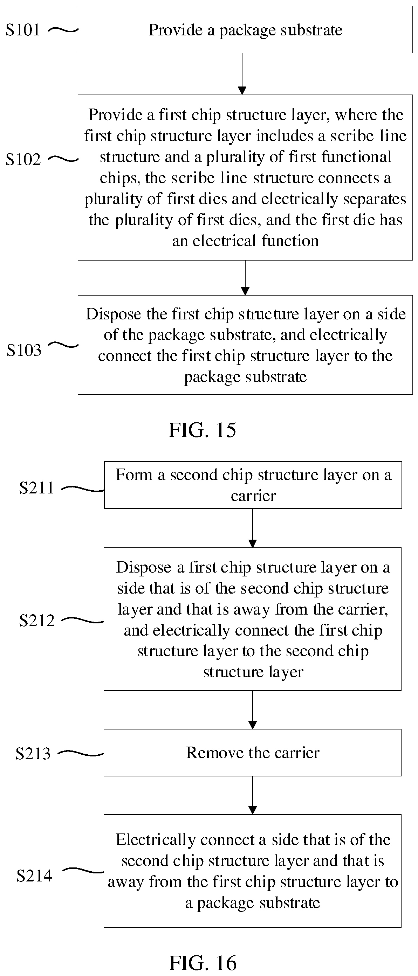

Based on this, an embodiment of this application further provides a manufacturing method of the chip integrated structure 1. The chip integrated structure 1 in the foregoing embodiment may be manufactured by using the manufacturing method of the chip integrated structure 1. FIG. 15 is a flowchart of steps of the manufacturing method of the chip integrated structure 1 according to an embodiment of this application. As shown in FIG. 15, with reference to FIG. 14, the manufacturing method of the chip integrated structure 1 may include the following steps S101 to S103.

S101: Provide a package substrate.

The package substrate 30 may be a circuit board having a wiring circuit, or may be a substrate including silicon (for example, monocrystalline silicon), ceramics, glass, or any other appropriate material. In some embodiments, the package substrate 30 may be provided with a plurality of structures for forming electrical connections, for example, a solder pad structure located on an upper surface of the package substrate 30, a contact structure located on a lower surface of the package substrate 30, and a line structure located inside the package substrate 30.

In this embodiment, after the package substrate 30 is provided, step S102 is further included.

S102: Provide a first chip structure layer, where the first chip structure layer includes a scribe line structure and a plurality of first dies, the scribe line structure connects the plurality of first dies and electrically separates the plurality of first dies, and the first die has an electrical function.

Because the scribe line structure 12 connects the plurality of first dies 11 and separates the plurality of first dies 11, each first die 11 is one die. That is, the plurality of first dies 11 are a plurality of dies located in the same wafer 100, and adjacent dies are connected through the scribe line structure 12. Herein, a process of manufacturing the first chip structure layer 10 may be as described in the foregoing embodiment, and details are not described herein again.

As described in the foregoing embodiment, there may be a plurality of first chip structure layers 10, and adjacent first chip structure layers 10 may be electrically connected through a first redistribution layer 50.

In a process of sequentially stacking the plurality of first chip structure layers 10, one first redistribution layer 50 may be disposed on a side of the first chip structure layer 10, and then the 2^{nd} first chip structure layer 10 is disposed on the other side of the first redistribution layer 50, ...., and so on. The foregoing disposing can implement an electrical connection between any two adjacent first chip structure layers 10. A manufacturing process of the first redistribution layer 50 may include a redistribution process and an interface bonding process in a related process. Details are not described in this embodiment of this application.

In this embodiment, after the first chip structure layer 10 is provided, where the first chip structure layer 10 includes the scribe line structure 12 and the plurality of first dies 11, the scribe line structure 12 connects the plurality of first dies 11 and separates the plurality of first dies 11, step S103 is further included.

S103: Dispose the first chip structure layer on a side of the package substrate, and electrically connect the first chip structure layer to the package substrate.

In conclusion, the foregoing disposing helps reduce a spacing between adjacent first dies 11 in the first chip structure layer 10, to increase a quantity of first dies 11 per unit area in the first chip structure layer 10, and enhance performance of the chip integrated structure 1. For example, when the first die 11 includes a memory chip, the quantity of first dies 11 per unit area in the first chip structure layer 10 increases, and this helps increase a storage capacity of the first chip structure layer 10, and further helps increase a storage capacity of the chip integrated structure 1. When the first die 11 includes a logic chip, a quantity of first dies 11 per unit area in the first chip structure layer 10 increases, and this helps increase a computing processing rate of the first chip structure layer 10, and further helps increase a computing processing rate of the chip integrated structure 1.

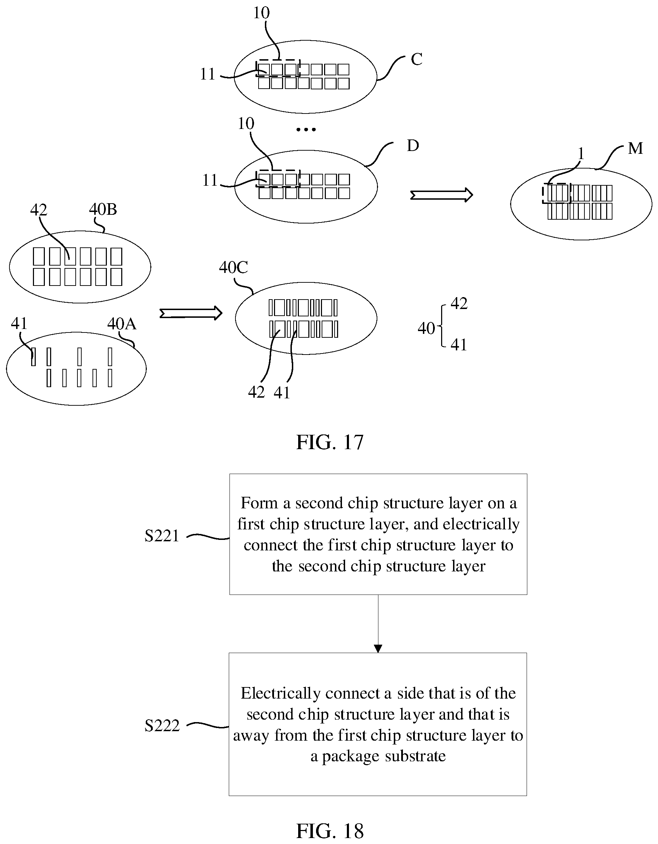

FIG. 16 is a flowchart of steps of another manufacturing method of the chip integrated structure 1 according to an embodiment of this application. FIG. 17 is a diagram of a structure of a manufacturing process in the manufacturing method of the chip integrated structure 1 in FIG. 16. As shown in FIG. 16 and FIG. 17, in some embodiments, the manufacturing method of the chip integrated structure 1 may include the following steps S211 to S214.

As shown in FIG. 17, the step of providing the first chip structure layer 10 may include: providing the plurality of first chip structure layers 10, where the plurality of first chip structure layers 10 may be respectively located in different wafers.

As described in the foregoing embodiment, the plurality of first chip structure layers 10 are sequentially stacked, and any two adjacent first chip structure layers 10 are electrically connected. In some embodiments, wafers in which the plurality of first chip structure layers 10 are located may be sequentially stacked, and any two adjacent wafers are electrically connected. For example, a wafer C and a wafer D each may include a plurality of first chip structure layers 10, the wafer C and the wafer D are stacked, and the wafer C and the wafer D are electrically connected, so that a first chip structure layer 10 in the wafer C and a corresponding first chip structure layer 10 in the wafer D are stacked, and the two corresponding first chip structure layers 10 are electrically connected. The step of sequentially stacking the wafers in which the plurality of first chip structure layers 10 are located may be as described in the foregoing embodiment, and details are not described herein again.

In this embodiment of this application, after the first chip structure layer 10 is provided, and before the first chip structure layer 10 is disposed on a side of the package substrate 30, and the first chip structure layer 10 is electrically connected to the package substrate 30, step S211 is further included.

S211: Form a second chip structure layer on a carrier.

It may be understood that because a chip is thin, in a manufacturing process of the second chip structure layer 40, a carrier 40C (carrier) needs to be used as a temporary bonding structure, to facilitate structure manufacturing of the chip on the carrier 40C. The carrier 40C may be referred to as a wafer carrier layer, and the wafer carrier layer may be connected to a corresponding chip by silicon fusion bonding (Fusion Bonding). Finally, a carrier layer of a wafer 100 may be removed by polishing. Alternatively, the wafer carrier layer may be bonded to a corresponding chip by temporary bonding (by bonding adhesive with a bonding film layer), and finally the wafer carrier layer may be removed by thermal debonding.

In this embodiment, the step of forming the second chip structure layer 40 on the carrier 40C may include: selecting a structure chip 41 from a first wafer 40A, and disposing the selected structure chip 41 on the carrier 40C.

As described in the foregoing embodiment, the structure chip 41 may be made of a semiconductor material, and may be a silicon substrate, a gallium arsenide (GaAs) substrate, a gallium arsenide phosphide (GaAsP) substrate, a silicon carbide (SiC) substrate, or the like. The structure chip 41 is disposed, to play a support role, and help improve stability of the chip integrated structure 1. Certainly, in some other embodiments, a quantity of structure chips 41 may be set according to an actual requirement, or the structure chip 41 may be omitted.

In this embodiment, the step of forming the second chip structure layer 40 on the carrier 40C may further include: selecting a second die 42 from a second wafer 40B, and disposing the selected second die 42 on the carrier 40C.

In a process of disposing the second die 42 and the structure chip 41, the second die 42 and the structure chip 41 may be spaced apart. Herein, the second die 42 and the structure chip 41 may be arranged according to an actual requirement. For example, one second die 42 and two structure chips 41 may be disposed in the second chip structure layer 40, and the two structure chips 41 are respectively disposed on two sides of the second die 42.

In some examples, the first wafer 40A and the second wafer 40B may be of different wafer structures. The required structure chip 41 may be cut off from the first wafer 40A by selection, and then the cut-off structure chip 41 is disposed on the carrier 40C. Similarly, the required second die 42 may be diced from the second wafer 40B by selection, and then the cut-off second die 42 is disposed on the carrier 40C. Herein, both the selected structure chip 41 and the second die 42 are chips with qualified quality.

In this embodiment, the step of forming the second chip structure layer 40 on the carrier 40C may further include: after the second die 42 and the structure chip 41 are disposed on the carrier 40C, forming an isolating structure 43 between the structure chip 41 and the second die 42, where the structure chip 41, the second die 42, and the isolating structure 43 jointly form the second chip structure layer 40.

Because the second die 42 and the structure chip 41 are spaced apart, there is a gap between the second die 42 and the structure chip 41, and an isolating material may be filled in the gap, to form the isolating structure 43. In some embodiments, after a plurality of isolating structures 43 are formed, a side that is of the second chip structure layer 40 and that is away from the carrier 40C, may be flattened by using a chemical mechanical grinding (chemical mechanical polishing, CMP) process, to facilitate subsequent processing and manufacturing.

In this embodiment, before the first chip structure layer 10 is disposed on a side of the package substrate 30, the first chip structure layer 10 is electrically connected to the package substrate 30, and after the second chip structure layer 40 is formed on the carrier 40C, step S212 is further included.

S212: Dispose the first chip structure layer on a side that is of the second chip structure layer and that is away from the carrier, and electrically connect the first chip structure layer to the second chip structure layer.

As shown in FIG. 13, the chip integrated structure 1 may further include a second redistribution layer 60. The second redistribution layer 60 may be disposed on the side that is of the second chip structure layer 40 and that is away from the carrier 40C, and then the first chip structure layer 10 is disposed on a side that is of the second redistribution layer 60 and that is away from the carrier 40C. A structure of the second redistribution layer 60 may be as described in the foregoing embodiment, and details are not described herein again.

In an embodiment in which there are a plurality of first chip structure layers 10, wafers (for example, the wafer C and the wafer D that are stacked in FIG. 17, and the wafer C and the wafer D are electrically connected to each other) in which the plurality of first chip structure layers 10 are located are electrically connected to the second redistribution layer 60, so that the wafers are stacked, and any first chip structure layer 10 is electrically connected to the second chip structure layer 40.

In this embodiment, the step of disposing the first chip structure layer 10 on a side of the package substrate 30 and electrically connecting the first chip structure layer 10 to the package substrate 30 further includes step S213.

S213: Remove the carrier.

The step of removing the carrier 40C may be as described in the foregoing embodiment, and is not described herein again.

In this embodiment, after the carrier 40C is removed, the step of disposing the first chip structure layer 10 on a side of the package substrate 30 and electrically connecting the first chip structure layer 10 to the package substrate 30 further includes step S214.

S214: Electrically connect a side that is of the second chip structure layer and that is away from the first chip structure layer to the package substrate.

As shown in FIG. 13, the chip integrated structure 1 may further include a second connecting member 20. The step of electrically connecting the side that is of the second chip structure layer 40 and that is away from the first chip structure layer 10 to the package substrate 30 further includes: disposing the second connecting member 20 on the side that is of the second chip structure layer 40 and that is away from the first chip structure layer 10, and disposing the package substrate 30 on a side that is of the second connecting member 20 and that is away from the second chip structure layer 40, so that the second chip structure layer 40 is electrically connected to the package substrate 30 through the second connecting member 20. A structure of the second connecting member 20 may be the same as that described in the foregoing embodiment. This is not specifically limited in this embodiment of this application.

In this embodiment, after the side that is of the second chip structure layer 40 and that is away from the first chip structure layer 10 is electrically connected to the package substrate 30, a wafer M can be formed. According to the foregoing steps, the package substrate 30, the second chip structure layer 40, and the first chip structure layer 10 can be stacked and electrically connected, to form the chip integrated structure 1. The wafer M includes a plurality of chip integrated structures 1, and the wafer M may be diced to obtain the plurality of independent chip integrated structures 1.

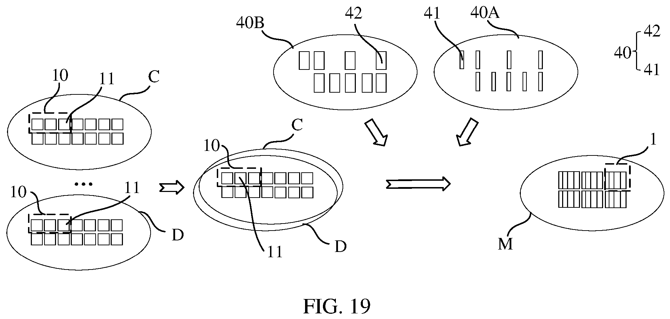

FIG. 18 is a flowchart of steps of another manufacturing method of the chip integrated structure 1 according to an embodiment of this application. FIG. 19 is a diagram of a structure of the chip integrated structure 1 in a manufacturing process in the manufacturing method of the chip integrated structure 1 in FIG. 18. As shown in FIG. 18 and FIG. 19, in some other embodiments, the manufacturing method of the chip integrated structure 1 may include the following steps S221 and S222.

As shown in FIG. 19, the step of providing the first chip structure layer 10 may include: providing the plurality of first chip structure layers 10, where the plurality of first chip structure layers 10 may be respectively located in different wafers.

As described in the foregoing embodiment, the plurality of first chip structure layers 10 are sequentially stacked, and any two adjacent first chip structure layers 10 are electrically connected. In some embodiments, wafers in which the plurality of first chip structure layers 10 are located may be sequentially stacked, and any two adjacent wafers are electrically connected. For example, a wafer C and a wafer D each may include a plurality of first chip structure layers 10, the wafer C and the wafer D are stacked, and the wafer C and the wafer D are electrically connected, so that a first chip structure layer 10 in the wafer C and a corresponding first chip structure layer 10 in the wafer D are stacked, and the two corresponding first chip structure layers 10 are electrically connected. The step of sequentially stacking the wafers in which the plurality of first chip structure layers 10 are located may be as described in the foregoing embodiment, and details are not described herein again. In this embodiment, after the first chip structure layer 10 is provided, and before the first chip structure layer 10 is disposed on a side of the package substrate 30, and the first chip structure layer 10 is electrically connected to the package substrate 30, the method further includes step S221.

S221: Form a second chip structure layer on the first chip structure layer, and electrically connect the first chip structure layer to the second chip structure layer.

In this embodiment, the step of forming the second chip structure layer 40 on the first chip structure layer 10 and electrically connecting the first chip structure layer 10 to the second chip structure layer 40 may include: selecting a structure chip 41 from a first wafer 40A, and disposing the selected structure chip 41 on the first chip structure layer 10, so that the structure chip 41 is connected to the first chip structure layer 10.

As shown in FIG. 13, before the structure chip 41 is disposed on the first chip structure layer 10, a second redistribution layer 60 may be formed on the first chip structure layer 10, and then the structure chip 41 is disposed on a side that is of the second redistribution layer 60 and that is away from the first chip structure layer 10, so that the structure chip 41 is connected to the first chip structure layer 10 through the second redistribution layer 60.

In this embodiment, the step of forming the second chip structure layer 40 on the first chip structure layer 10, and electrically connecting the first chip structure layer 10 to the second chip structure layer 40 may further include: selecting a second die 42 from a second wafer 40B, and disposing the selected second die 42 on the first chip structure layer 10, so that the second die 42 is electrically connected to the first chip structure layer 10.

The second die 42 may be disposed on a side that is of the second redistribution layer 60 and that is away from the first chip structure layer 10, so that the second die 42 is electrically connected to the first chip structure layer 10 through the second redistribution layer 60.

In an embodiment in which there are a plurality of first chip structure layers 10, the second redistribution layer 60 is formed on a wafer (for example, the wafer C and the wafer D that are stacked in FIG. 19, and the wafer C and the wafer D are electrically connected to each other) on which the plurality of first chip structure layers 10 are located, and then the structure chip 41 and the second die 42 are disposed on a side of the second redistribution layer 60 that is away from the first chip structure layer 10. In this way, the wafers and the chips are stacked.

In this embodiment, after the structure chip 41 and the second die 42 are disposed on the side that is of the second redistribution layer 60 and that is away from the first chip structure layer 10, the method further includes: forming an isolating structure 43 between the structure chip 41 and the second die 42, where the structure chip 41, the second die 42, and the isolating structure 43 jointly form the second chip structure layer 40.

Because the second die 42 and the structure chip 41 are spaced apart, there is a gap between the second die 42 and the structure chip 41, and an isolating material may be filled in the gap, to form the isolating structure 43. In this embodiment, the step of disposing the first chip structure layer 10 on a side of the package substrate 30 and electrically connecting the first chip structure layer 10 to the package substrate 30 further includes step S222.

S222: Electrically connect a side that is of the second chip structure layer and that is away from the first chip structure layer to the package substrate.

As described in the foregoing embodiment, as shown in FIG. 13, the chip integrated structure 1 may further include a second connecting member 20. The second connecting member 20 may be disposed on the side that is of the second chip structure layer 40 and that is away from the first chip structure layer 10, and the package substrate 30 is disposed on a side that is of the second connecting member 20 and that is away from the second chip structure layer 40, so that the second chip structure layer 40 is electrically connected to the package substrate 30 through the second connecting member 20. A structure of the second connecting member 20 may be the same as that described in the foregoing embodiment. This is not specifically limited in this embodiment of this application.

In this embodiment, after the side that is of the second chip structure layer 40 and that is away from the first chip structure layer 10 is electrically connected to the package substrate 30, a wafer M can be formed. According to the foregoing steps, the package substrate 30, the second chip structure layer 40, and the first chip structure layer 10 can be stacked and electrically connected, to form the chip integrated structure 1. The wafer M includes a plurality of chip integrated structures 1, and the wafer M may be diced to obtain the plurality of independent chip integrated structures 1.

In this embodiment of this application, steps of stacking the package substrate 30, the second chip structure layer 40, and the first chip structure layer 10 may be not limited to the foregoing two implementations. This is not specifically limited in this embodiment of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip integrated structure, comprising a package substrate and a first chip structure layer, wherein the first chip structure layer is located on a side of the package substrate and is electrically connected to the package substrate; and
the first chip structure layer comprises a scribe line structure and a plurality of first dies, the scribe line structure connects the plurality of first dies and electrically separates the plurality of first dies, and the first die has an electrical function.

2. The chip integrated structure according to claim 1, wherein
the first die comprises a first substrate, the scribe line structure comprises a first connection substrate, and the first connection substrate and the first substrate are connected and are disposed at a same layer.

3. The chip integrated structure according to claim 1 or 2, wherein the first die further comprises a seal ring, the seal ring is located in an edge region of the first die, and the seal ring is adjacent to the scribe line structure.

4. The chip integrated structure according to claim 2 or 3, wherein
the first die further comprises a plurality of first insulation layers, the plurality of first insulation layers are located on the first substrate, and the plurality of first insulation layers are stacked;
the scribe line structure further comprises a plurality of first insulation connection layers, the plurality of first insulation connection layers are located on the first connection substrate, and the plurality of first insulation connection layers are stacked; and
the plurality of first insulation connection layers are connected to the plurality of first insulation layers in one-to-one correspondence, and a first insulation connection layer and a first insulation layer that are correspondingly connected are disposed at a same layer.

5. The chip integrated structure according to any one of claims 2 to 4, wherein
the first die further comprises a plurality of first conductive layers, the plurality of first conductive layers are located on the first substrate, and the plurality of first conductive layers are stacked;
the scribe line structure further comprises the plurality of first insulation connection layers, the plurality of first insulation connection layers are located on the first connection substrate, and the plurality of first insulation connection layers are stacked; and
a quantity of the plurality of first insulation connection layers is the same as a quantity of the plurality of first conductive layers.

6. The chip integrated structure according to claim 5, wherein the scribe line structure comprises a plurality of metal layers, the plurality of metal layers are located on the first connection substrate, and the plurality of metal layers are stacked; and
the plurality of metal layers are in one-to-one correspondence with a part of the plurality of first conductive layers, and a metal layer and a first conductive layer that are in correspondence are disposed at a same layer and are electrically isolated from each other.

7. The chip integrated structure according to claim 6, wherein at least a part of the plurality of metal layers form a test structure.

8. The chip integrated structure according to any one of claims 1 to 7, wherein the scribe line structure comprises a positioning mark.

9. The chip integrated structure according to any one of claims 1 to 8, wherein
the scribe line structure comprises a first sub-scribe line structure, the first sub-scribe line structure extends in a first direction, a value range of a length of the first sub-scribe line structure in a second direction is 80 micrometers to 120 micrometers, the first direction and the second direction are perpendicular to each other and are both parallel to the package substrate;
and/or,
the scribe line structure comprises a second sub-scribe line structure, the second sub-scribe line structure extends in the second direction, a value range of a length of the second sub-scribe line structure in the first direction is 80 micrometers to 120 micrometers, the first direction and the second direction are perpendicular to each other and are both parallel to the package substrate.

10. The chip integrated structure according to any one of claims 1 to 9, wherein
there are a plurality of first chip structure layers, the plurality of first chip structure layers are stacked in a third direction, and the third direction is perpendicular to the package substrate; and
two adjacent first chip structure layers are electrically connected.

11. The chip integrated structure according to claim 10, further comprising a first redistribution layer, wherein the first redistribution layer is located between two adjacent first chip structure layers;
the first redistribution layer comprises a first portion and a second portion that are stacked, the first portion is electrically connected to one first chip structure layer, and the second portion is electrically connected to the other first chip structure layer; and
the first redistribution layer further comprises a first bonding portion and a second bonding portion, the first bonding portion is located on a side that is of the first portion and that is close to the second portion, the second bonding portion is located on a side that is of the second portion and that is close to the first portion, and the second portion is bonded with the first portion through the first bonding portion and the second bonding portion.

12. The chip integrated structure according to claim 11, wherein a cross-sectional area of an end that is of the first bonding portion and that is close to the second portion is greater than a cross-sectional area of an end that is of the first bonding portion and that is close to the first portion; and/or
a cross-sectional area of an end that is of the second bonding portion and that is close to the first portion is greater than a cross-sectional area of an end that is of the second bonding portion and that is close to the second portion.

13. The chip integrated structure according to claim 11, wherein the first bonding portion comprises a first connection pad and a second connection pad that are stacked, the first connection pad is closer to the first portion than the second connection pad, and a cross-sectional area of the second connection pad is greater than a cross-sectional area of the first connection pad in a direction parallel to the package substrate; and/or
the second bonding portion comprises a third connection pad and a fourth connection pad that are stacked, the third connection pad is closer to the second portion than the fourth connection pad, and a cross-sectional area of the fourth connection pad is greater than a cross-sectional area of the third connection pad in the direction parallel to the package substrate.

14. The chip integrated structure according to any one of claims 11 to 13, wherein in the plurality of stacked first chip structure layers, the first chip structure layer that is farthest from the package substrate is a top structure layer, and the first chip structure layer located between the top structure layer and the package substrate is an intermediate structure layer; and
the intermediate structure layer comprises a first conductive via that passes through the first die in the third direction, and the top structure layer is further electrically connected to the first conductive via of the intermediate structure layer through the redistribution layer.

15. The chip integrated structure according to any one of claims 1 to 14, further comprising a second chip structure layer, wherein the second chip structure layer and the first chip structure layer are stacked, and the second chip structure layer comprises a structure chip, a second die, and an isolating structure located between the structure chip and the second die; and
the second die comprises a second substrate and a functional layer located on the second substrate, and the first chip structure layer is electrically connected to the functional layer of the second die.

16. The chip integrated structure according to claim 15, wherein a material of the isolating structure comprises one or a combination of silicon oxide, silicon nitride, and silicon oxynitride.

17. The chip integrated structure according to claim 15, further comprising a second redistribution layer, wherein the second chip structure layer is located between the first chip structure layer and the package substrate, the second redistribution layer is located between the first chip structure layer and the second chip structure layer, the first chip structure layer and the second chip structure layer are electrically connected through the second redistribution layer, and the second chip structure layer is electrically connected to the package substrate.

18. The chip integrated structure according to claim 17, wherein the second die further comprises a second conductive via that passes through the second substrate, the functional layer is closer to the package substrate than the second substrate, and the functional layer is electrically connected to the package substrate; and
one end of the second conductive via is electrically connected to the functional layer, and the other end of the second conductive via is electrically connected to the second redistribution layer.

19. The chip integrated structure according to claim 17, wherein the second die further comprises a second conductive via that passes through the second substrate, the functional layer is farther away from the package substrate than the second substrate, and the functional layer is electrically connected to the second redistribution layer; and
one end of the second conductive via is electrically connected to the functional layer, and the other end of the second conductive via is electrically connected to the package substrate.

20. The chip integrated structure according to any one of claims 1 to 19, further comprising a third die, wherein the third die and the first chip structure layer are stacked, and the third die is electrically connected to the package substrate.

21. A manufacturing method for a chip integrated structure, comprising:
providing a package substrate;
providing a first chip structure layer, wherein the first chip structure layer comprises a scribe line structure and a plurality of first dies, and the scribe line structure connects the plurality of first dies and separates the plurality of first dies; and
disposing the first chip structure layer on a side of the package substrate, and electrically connecting the first chip structure layer to the package substrate.

22. The manufacturing method for a chip integrated structure according to claim 21, wherein there are a plurality of first chip structure layers; and
disposing the first chip structure layer on a side of the package substrate, and electrically connecting the first chip structure layer to the package substrate comprises:
sequentially stacking the plurality of first chip structure layers on the package substrate, wherein in the plurality of first chip structure layers, the first chip structure layer closest to the package substrate is electrically connected to the package substrate, and any two adjacent first chip structure layers are electrically connected.

23. The manufacturing method for a chip integrated structure according to claim 21 or 22, wherein before disposing the first chip structure layer on a side of the package substrate, and electrically connecting the first chip structure layer to the package substrate, the method further comprises:
forming a second chip structure layer on a carrier; and
disposing the first chip structure layer on a side that is of the second chip structure layer and that is away from the carrier, and electrically connecting the first chip structure layer to the second chip structure layer; and
disposing the first chip structure layer on a side of the package substrate, and electrically connecting the first chip structure layer to the package substrate comprises:
removing the carrier; and
electrically connecting a side that is of the second chip structure layer and that is away from the first chip structure layer to the package substrate.

24. The manufacturing method for a chip integrated structure according to claim 22, wherein forming the second chip structure layer on the carrier comprises:
selecting a structure chip from a first wafer, and disposing the selected structure chip on the carrier;
selecting a second die from a second wafer, and disposing the selected second die on the carrier; and
forming an isolating structure between the structure chip and the second die, wherein the structure chip, the second die, and the isolating structure jointly form the second chip structure layer.

25. The manufacturing method for a chip integrated structure according to claim 21 or 22, wherein before disposing the first chip structure layer on a side of the package substrate, and electrically connecting the first chip structure layer to the package substrate, the method further comprises:
forming a second chip structure layer on the first chip structure layer, and electrically connecting the first chip structure layer to the second chip structure layer; and
disposing the first chip structure layer on a side of the package substrate, and electrically connecting the first chip structure layer to the package substrate further comprises:
electrically connecting a side that is of the second chip structure layer and that is away from the first chip structure layer to the package substrate.

26. The manufacturing method for a chip integrated structure according to claim 25, wherein forming the second chip structure layer on the first chip structure layer, and electrically connecting the first chip structure layer to the second chip structure layer comprises:
selecting a structure chip from a first wafer, and disposing the selected structure chip on the first chip structure layer, so that the structure chip is connected to the first chip structure layer;
selecting a second die from a second wafer, and disposing the selected second die on the first chip structure layer, so that the second die is electrically connected to the first chip structure layer; and
forming an isolating structure between the structure chip and the second die, wherein the structure chip, the second die, and the isolating structure jointly form the second chip structure layer.

27. An electronic device, comprising a printed circuit board and the chip integrated structure according to any one of claims 1 to 20, wherein the chip integrated structure is electrically connected to the printed circuit board.
